(19)

Europäisches
Patentamt
European
Patent Office
Office européen
des brevets

(11) **EP 4 167 268 A1**

(12) **EUROPEAN PATENT APPLICATION**
published in accordance with Art. 153(4) EPC

(43) Date of publication:
**19.04.2023 Bulletin 2023/16**

(21) Application number: **21822158.8**

(22) Date of filing: **26.05.2021**

(51) International Patent Classification (IPC):
**H01J 37/317** (2006.01)    **H01J 37/304** (2006.01)
**G03F 7/20** (2006.01)

(86) International application number:
**PCT/CN2021/096009**

(87) International publication number:
**WO 2021/249189 (16.12.2021 Gazette 2021/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **11.06.2020 CN 202010533718**

(71) Applicant: **Parcan NanoTech Co., Ltd**
**Shanghai 201821 (CN)**

(72) Inventors:
• **ZHOU, Xiangqian**
**Shanghai 200020 (CN)**
• **RANGELOW, Ivo**
**34225 Baunatal (DE)**

(74) Representative: **Scholl, Matthias**
**Friedrichstraße 114a**
**10117 Berlin (DE)**

(54) **SUB-NANOSCALE HIGH-PRECISION PHOTOLITHOGRAPHY WRITING FIELD STITCHING METHOD, USED PHOTOLITHOGRAPHY SYSTEM, WAFER, AND METHOD FOR DETERMINING ELECTRON BEAM DRIFT**

(57)    A sub-nanoscale high-precision photolithography writing field stitching method, comprising: a photosensitive glue layer (2) coats the surface of a wafer (1) to undergo photolithography, and after the surface of the photosensitive glue layer (2) is exposed, the exposed pattern thereof produces tiny concave-convex structures; and the concave-convex structure patterns can be identified by using a nano-contact sensor (39), and same are used as in-situ alignment coordinate identifiers (8, 10, 44, 45). By comparing the position coordinates of writing fields before and after exposure and before and after moving the wafer (1), the deviation in stitching is calculated, and high-precision photolithography stitching is performed on the wafer (1) by using negative feedback control, which overcomes the defect in existing non-in-situ, remote writing field, blind open-loop photolithography stitching technologies in which stitching precision is poor due to the impact of the precision of the mechanical movement of a wafer workbench and the long-term drift of an electron beam (17). A sub-nanoscale high-precision writing field stitching lithography system, a pre-treated wafer (1), a method for determining electron beam (17) drift, and a sub-nanoscale high-precision photolithography writing field longitudinal stitching method.

**FIG. 8**

Processed by Luminess, 75001 PARIS (FR)

**Description**

The disclosure relates to lithography technology used in the fabrication of integrated circuits, optoelectronic devices, etc., in particular to the precise alignment technology in the horizontal and/or in vertical stitching by positioning an electron beam (generally referring to an electron beam, a photon beam, an ion beam or an atomic beam). In particular, it is a sub-nano-level high-precision lithography writing field stitching method based on the spatial in-situ closed-loop control technology of writing field stitching in an electron beam lithography system, a lithography equipment and a pre-processed wafer.

The development of microelectronics and optoelectronics has led to a rapid development of integrated circuit chips, integrated optics, and quantum computing industries. These industries have become the basis of modern computers, display screens and even the core devices and chips of the entire information industry. At present, the technology node of the modern chip industry has reached 5 nanometers or even smaller.

The manufacture of micro-devices and nano-devices such as chips cannot be achieved without lithography technology. Lithography technology includes electron beam lithography, ordinary optical lithography, EUV (extreme ultraviolet) lithography, ion beam lithography, and scanning probe lithography. With the help of these key lithography technologies, fine lithography patterns and even all-encompassing micro and nano device structures can be manufactured, including integrated circuit chips and optoelectronic integrated chips.

In today's era, multi-mask pattern technology promotes the semiconductor industry to greatly improve the integration of integrated circuits, while also increasing the complexity of chip manufacturing. A chip with a 28 nm technology node requires 40 to 50 masks (length and width, for example, 20 mm). From this calculation, a chip with a 14-nanometer technology node and a 10-nanometer technology node requires 60 masks (length and width, for example, 20 mm), while a 7-nanometer technology node or even a smaller chip requires more masks. There are as many as 80 to 85 masks, and the 5nm technology node requires 100 masks and 120 photolithography processes! Solving the problem of the accuracy of stitching alignment errors in lithography and the alignment of these masks is always a big problem for the production of templates with large wafer sizes and chip sizes, which requires more precision chip lithography manufacturing process (even less than 1 nanometer), currently there is no such high-precision lithography manufacturing technology in the world.

The electron beam lithography system (EBL) in the prior art is a nano-level lithography technology widely used in scientific research, sample production, scientific research, and industrial template production and manufacture. This electron beam lithography system has only one limited writing field for exposure, so the large pattern must be divided into many adjacent writing fields and the wafer workbench moves to expose the writing fields one by one. It is an ideal requirement for the writing field to deviate from the perfect alignment stitching next to each other, but in fact, it is impossible to be without error due to mechanical movement and electron beam drift, and the error is not small and difficult to overcome. This error is called stitching error.

The wafer referred to here not only refers to wafers, but also includes parts of wafers and non-wafer samples.

Before photolithography, a flat layer of photosensitive resist is coated on the wafer without any other structure on the surface. By scanning and exposing with the electron beam on the layer of the photosensitive resist layer based on a preset pattern, a chemical reaction is generated in the photosensitive resist layer. The exposed pattern on the photoresist layer level will be retained or removed by chemical development, and the pattern exposed by the electron beam is transferred to the photoresist layer pattern, and finally transferred to the wafer by etching. Due to the lack of in-situ feedback information (here the so-called in-situ refers to the coordinate position within the electron beam scanning writing field), traditional electron beam lithography is an open-loop controlled "blind operation", that is, once the photosensitive resist layer is coated, the electron beam will not be able to scan the surface of the wafer anymore, because electron beam scanning means the exposure of the photosensitive resist layer on the wafer. The exposed position can only be observed in an ex-situ after the photosensitive resist layer is developed. This leads to any improvement in the lithography process too late and irreversible. The stitching quality of writing field patterns cannot be measured in advance before exposure and fed back to the workbench for further movement correction. Furthermore, the mechanical action of the wafer workbench is too slow to adapt to the drift of the electron beam, and the resulting errors cannot be overcome.

Therefore, how to find a way to measure and calibrate the alignment error in situ during the entire lithography exposure process of the required pattern is a way to improve the accuracy level of today's lithography technology, but no one has found such a method nowadays, of course, there is no lithography system for implementing this method.

To facilitate full disclosure and easy understanding of the following technical problems that the disclosure will strive to solve, before describing the technical solutions and specific embodiments of the disclosure, the following first introduces technical terms and functions that are helpful for full description and easy public understanding principle.

The electron beam described in the disclosure may be a Gaussian beam or a Variable Shaped Beam. If there is no special description, the electron beam below refers to a Gaussian electron beam. If the Variable Shaped Beam spot is not large, it can also be a Variable Shaped Beam.

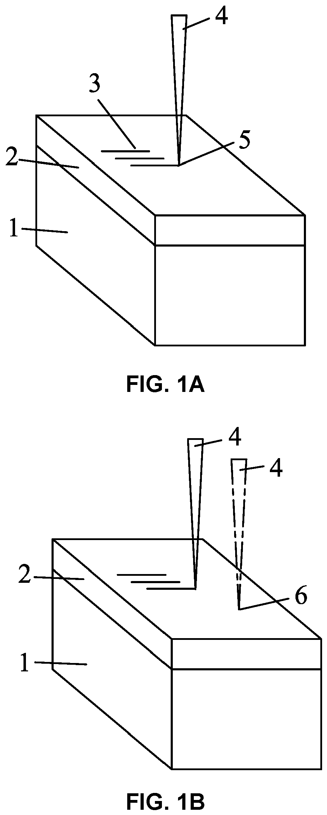

FIG. **1** illustrates schematically the exposure process of the Gaussian beam. The Gaussian electron beam is focused on the surface of the photosensitive resist layer and exposed. The coordinates of the electron beam refer to the coordinates of the surface of the photosensitive resist layer where the electron beam is aimed. The coordinates of the electron beam represent the position where the electron beam is exposed on the surface of the photosensitive resist layer.

To record accurate electron beam coordinates, here are some special coordinates: the coordinates on the photosensitive resist layer just exposed by the electron beam are CPJE, and the coordinates where the electron beam has been aimed but not yet exposed are CPTE. Both coordinates have a feature, that is, the electron beam coordinates are provided on the coordinates of the surface position of the photosensitive resist layer.

For the electron beam lithography system, the error caused by the movement of the wafer stage can be adjusted and compensated by the deflection of the electron beam. The method of finding the error is realized by the alignment mark on the wafer.

Through the electron beam lithography technology, the lithography pattern will be transferred to the photoresist layer through exposure, and then the lithography pattern will be transferred to the wafer through an etching process. It should be noted that in the prior art, the photosensitive resist layer coated on the wafer makes the surface of the wafer flat without any pattern structure. The photosensitive resist layer on the wafer forms the upper surface. This surface is "phobic to radiate" so that the electron beam cannot be irradiated (that is, exposed) for surface imaging before exposure, and cannot penetrate the photosensitive resist layer to obtain the underside pattern on the wafer of the photosensitive resist layer. Furthermore, the exposure of the lithography machine system must be precisely aligned with the positioning of the pattern. Although this positioning accuracy is limited by the errors of various systems and environmental factors, the basic problem is the open-loop control of most lithography machine systems, that is, the position of the electron beam on the wafer cannot be observed and tracked before and during exposure.

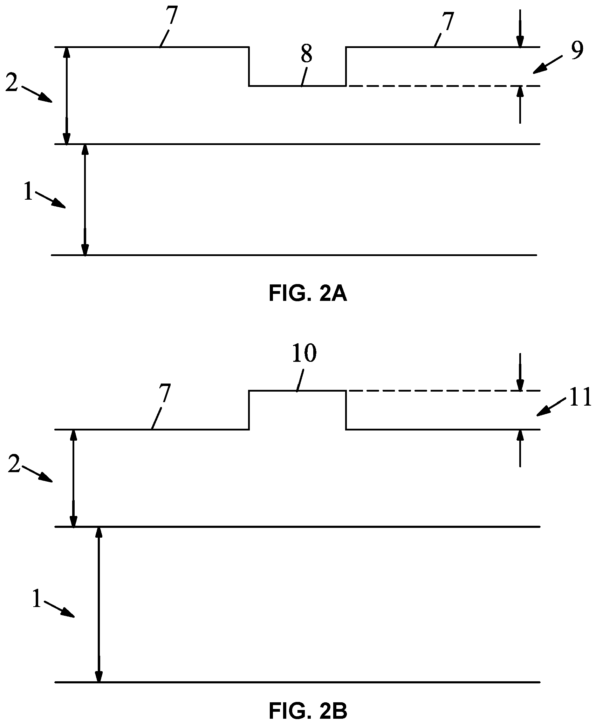

The alignment of electron beam lithography in the traditional sense is inherently flawed. The alignment marks (in FIG. **2**) are far away from the writing field, this will cause that the alignment of these marks to be written by electron beam lithography can be only finished indirectly by moving the wafer stage in the writing field stitching process, rather than precise direct in-situ alignment in the writing field, therefore will cause alignment errors. Accurate in-situ alignment refers to the alignment of the electron beam at the alignment mark in the writing field. In view of the fact that the repeat positioning accuracy of the electron beam in the writing field of the exposure area is generally less than 1 nanometer, the coordinate position of the electron beam deflection to any writing field of the exposure area is accurate within this range. The so-called in-situ alignment concept can be extended to that the alignment of the electron beam to any alignment mark in the writing field of the exposure area can be regarded as in-situ alignment.

For stitching alignment between writing fields, special alignment marks must be used to obtain the coincidence of the coordinates of the wafer pattern and the coordinates of the electron beam. Since the electron beam cannot use the imaging function of the electron microscope on the surface of the coated photosensitive resist layer, it is impossible to find the coordinates corresponding to the wafer pattern under the photosensitive resist layer before exposure. Therefore, a special writing field must be selected on the wafer. The coordinate position allows the electron beam to determine and even align the position of the wafer pattern. The electron microscope moves with the wafer workbench from a special coordinate position outside the writing field to the position of the exposure point of the electron beam. The position error caused by the mechanical movement accuracy and electronic drift greatly limits the current stitching accuracy of the writing fields.

Large-area pattern electron beam lithography

Large-area pattern lithography transfers the electron beam pattern design to the wafer, and these lithography patterns can meet various application requirements. These applications are facing a huge market, comprising optical gratings, large-area Fresnel lenses, extreme ultraviolet lithography masks for integrated circuits, distributed feedback lasers, semiconductor laser arrays, photonic crystals, large-scale memories, etc. The size (length) of the figures can be from 10 mm to more than 300 mm.

Since the writing field is very small, for large-area lithography, one writing field cannot be completed by one lithography step. Therefore, the stitching of many electron beam writing fields is needed. The stitching errors are accumulated to form serious system errors, so the required accuracy of stitching errors is very high.

Alignment mark

Without the deformation of the written pattern, the traditional electron beam lithography system can only write (expose) the pattern in a limited writing field. The size of this writing field is generally about 100 microns $\times$ 100 microns to 1 mm $\times$ 1 mm. This size is simply too small for many graphics applications that require a size of 20 mm $\times$ 20 mm to 200 mm $\times$ 200 mm. Large patterns can only be stitched into a large pattern by the movement of the wafer workbench. In this way, the total error by accumulating the alignment and stitching errors of a certain writing field pattern and adjacent patterns becomes very large.

Since the entire wafer is covered by the photosensitive resist layer and the entire wafer is a "useful" area, the alignment of electron beam lithography usually needs to use the position outside the writing field or even outside the entire wafer, that is, the edge of the wafer as the alignment coordinates, especially the alignment coordinates are selected at the position on the edge of the entire wafer, that is, the alignment coordinates are set in the "useless" area away from the writing field. The reason why these alignment coordinates far away from the writing field are accepted by the current industry is that these alignment coordinates are not in the area of the wafer that needs to be patterned, so they can be used as alignment coordinate marks by electron beam exposure (hereinafter referred to as alignment Mark), can be repeatedly "observed" by the electron beam of an electron microscope, that is, exposed.

These alignment coordinate marks will be aligned and connected by the movement of the wafer workbench. The control accuracy of the movement of the wafer workbench determines the accuracy of the writing field stitching error in a sense, and the high-precision writing field stitching requires to use expensive high-precision laser mobile workbench, because the main positioning accuracy deviation comes from the positioning error of the wafer stage in the moving direction and the incidental changes in other wafer coordinate directions caused by this movement, and the electron beam drift caused by the long time required for these movements.

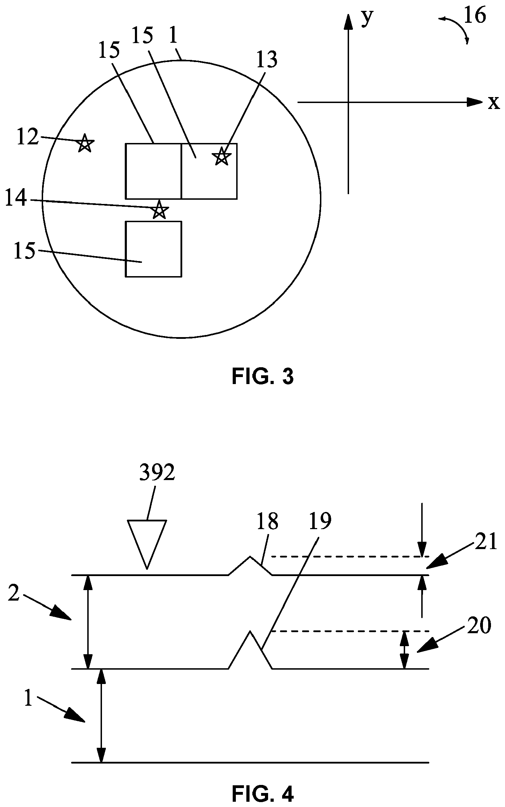

FIG. 3 shows the prior art "out-of-field mark" (alignment mark **12** set on the edge of the wafer, alignment mark **14** set between the writing fields), and the electron beam that has not been used so far to scan the "in-field-mark" (IA mark) with alignment mark **13**.

The alignment mark **12** provided at the edge of the wafer is set at the edge of the wafer and away from the writing field.

The alignment marks **14** provided between the writing fields are set between the writing fields (if there is space between the writing fields). In fact, there are many situations where no space is allowed between writing fields, such as gratings or Fresnel lenses. The grating lines cannot be broken between.

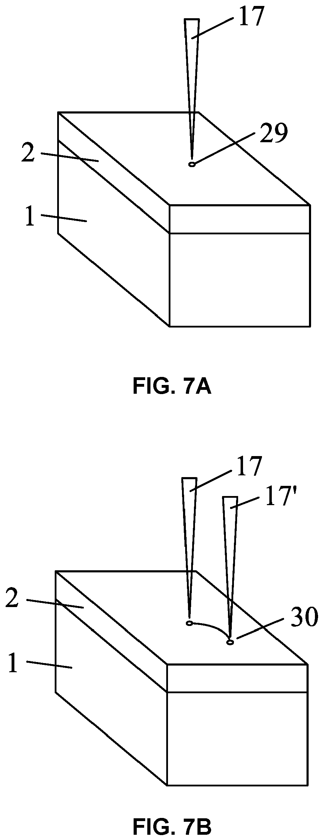

Both the alignment mark **12** and the alignment mark **14** require the movement of the wafer stage to aim the new writing field under the electron beam irradiation. The movement of the workbench not only leads to movement alignment errors, but also a longer alignment time, which leads to electron beam drift due to various unstable factors (such as temperature drift, humidity drift, etc., see FIG. **7**).

If the alignment mark is set in the writing field scanned by the electron beam, the alignment here does not require the movement of the wafer stage. Using this type of mark can avoid long-term alignment adjustment of the electron beam so that the drift of the electron beam can be reduced. This type of alignment mark, we tentatively call it "in-field mark" (IA mark). However, the in-field marker **13** occupies a relatively large area according to the method of the prior art, and until now, no one in the industry believes that it can be used to completely solve the problem of writing field stitching accuracy.

If the in-field marker **13** can be as small as a few nanometers to a few hundred nanometers, it will be very practical because it occupies a small area. However, until now, it is difficult to think of how to solve this problem, and there is no corresponding technical support that the mark in the field can be as small as a few nanometers to hundreds of nanometers, and there are means to identify them.

If this small in-field mark **13** is small enough in the electron beam writing field and is very closed (for example, within a few nanometers to tens of nanometers) to the coordinates of the surface of the photosensitive resist layer aimed at by the electron beam, this in-field coordinates become the align the coordinate mark (ISA mark) in the in-suit position defined in the disclosure

If the in-field mark **13** in the field is exactly under the electron beam coordinates, that is, the coordinates of the exposure pattern on the photosensitive resist layer/wafer exactly overlap the electron beam exposure coordinates (target coordinates), this field coordinates are referred to as "overlapped alignment coordinates mark" (OA mark) in the disclosure.

Since the repetitive position accuracy of the electron beam in the writing field is very high (generally within 1 nanometer), the marks in the writing field can be approximately regarded as in-situ alignment marks.

Three-dimensional alignment mark

Electron beam irradiation is used to sense and image alignment marks. These alignment marks are generally flat, that is, two-dimensional. However, the three-dimensional marks on the photosensitive resist layer and the surface of the wafer can also be used as alignment marks. For example, by measuring the peak position or recess position of the three-dimensional mark, a precise alignment coordinate can be determined. The uneven structure of the wafer surface generally causes the surface of the photosensitive resist layer covering it to follow the formation of the uneven structure, so that the uneven structure and position of the surface can be measured.

Electron beam induced change of photosensitive resist layer

Electron Beam Induced Change (EIRC) refers to changes in the chemical and/or physical properties of the photosensitive resist layer at the position exposed by electron beam radiation. Chemical changes comprise the electron beam causing a chemical reaction on the surface of the photosensitive resist layer, which causes the part of the irradiated photosensitive resist layer to change from an insoluble state to dissolving during development (positive tone), or the dissolved state becomes insoluble by exposure reaction (negative tone). The physical changes of the photosensitive resist layer caused by electron beam exposure comprise slight geometrical changes on the surface of the photosensitive resist layer, such as expansion or shrinkage on the sub-nanometer or nanometer order to form a concave-convex structure (see FIG. **2**). When the electron beam exposure transfers the electron beam pattern information to the photosensitive resist layer, the uneven structure on the photosensitive resist layer changes.

A method of generating three-dimensional marks is to induce the denaturation of the photosensitive resist layer by electron beams, and the electron beam induces modification of the photosensitive resist layer. The physical changes of the photosensitive resist layer caused by electron beam exposure comprise changes in the surface of the photosensitive resist layer, such as swelling or shrinking on the sub-nanometer or nanometer order to form a concave-convex structure. As shown in Figs. **2a** and **2b**, the exposure causes expansion or shrinkage of the photosensitive resist layer pattern in height, forming a three-dimensional geometric height pattern. This kind of deformation can be detected and sensed by nano-contact sensors (highly sensitive sensors) on the sub-nanometer scale.

Another way to generate three-dimensional marks is to preset a three-dimensional structure on the wafer, such as a three-dimensional protrusion: a miniature cone, a miniature pyramid or a miniature contact with diameter scale ranges from several nanometers to tens of nanometers. These microstructures can be realized by electron beam lithography or electron beam induced deposition technology. The three-dimensional marks **18** and **19** in FIG. **4** are the preset three-dimensional protrusions, and we will also call them the wafer protrusion alignment marks (HAMW marks) below.

On the three-dimensional protruding alignment mark **19** coated with a thin layer of photosensitive resist, the thickness of the photosensitive resist layer is, for example, between 10 nanometers and 300 nanometers, and the photosensitive resist layer on the three-dimensional protruding alignment mark **19** (HAMW) of the wafer will follow to become a three-dimensional structure. The height of this three-dimensional structure can be from a few nanometers to several tens of nanometers, and the position of the three-dimensional alignment mark **18** (HAMR) on the surface of the photosensitive resist layer is accurately given. This position in the vertical direction is completely equivalent to the position of the three-dimensional alignment mark of the wafer vertically below. In this way, we can accurately determine the horizontal coordinate of the wafer pattern. The important thing is that this horizontal coordinate can be set in the writing field. Setting these three-dimensional alignment marks can determine the accuracy of the alignment, so that the alignment does not depend on the accuracy of the wafer stage movement. This allows the use of a workbench with low mobile positioning accuracy. For example, a workbench with a positioning accuracy of 1 nanometer can be replaced by a workbench with a positioning accuracy of 1000 nanometers, which greatly reduces the cost of the workbench.

Lateral Stitching Alignment (LSA) Error

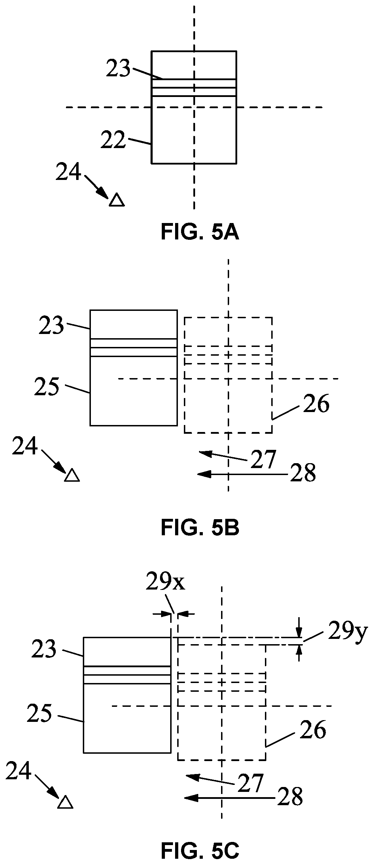

One of the great challenges of the electron beam lithography machine system is the huge stitching error between the previous writing field and the next adjacent writing field (FIGS. **5a-5c**). To expose a large-area pattern, it is necessary to use the movement of the wafer stage to stitch one writing field together to form a large pattern. According to the current electron beam lithography technology, the stitching between writing fields is realized by the movement of the wafer stage. The positioning accuracy of the new writing field greatly depends on the positioning accuracy of the workbench and the drift of the electron beam. In general, an extremely high-precision, high-priced laser stage with positioning accuracy within a few nanometers will be used. However, even an extremely high-precision laser stage is extremely sensitive to environmental changes (temperature, humidity, etc.) and it is difficult to achieve and repeat nano-level high precision.

The stitching error between two adjacent writing fields is generally +/-20 nm for a 100 KV electron beam lithography system and +/-35 nm for a 30 KV electron beam lithography system. For the stitching error of 35 nm writing field, in the worst case it means the stitching error of 700 nm, making this grating array useless! Such large-area high-precision applications particularly require smaller stitching errors, such as in the range of 1 nanometer.

Vertical Alignment (VA) Error

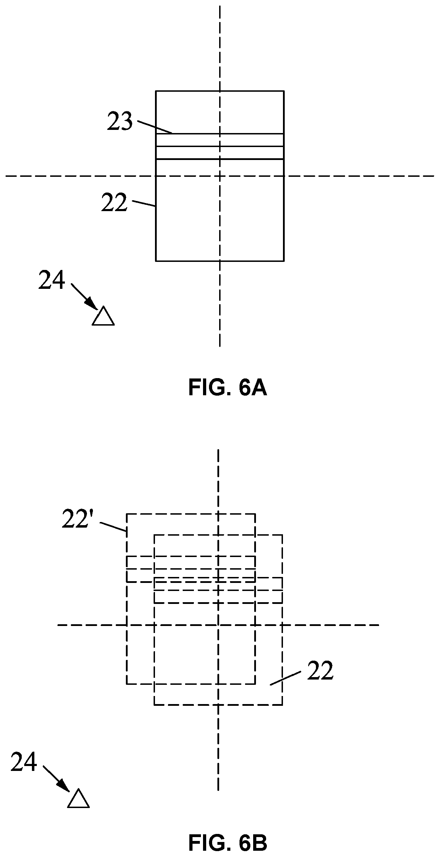

Vertical alignment refers to aligning the electron beam to the writing field **22** to be exposed in the exposure area (taking the photolithography grating **23** as an example), and aligning it with the corresponding coordinates of the previous writing field **22** that has been exposed before (FIGS. **6a-6b**). The difficulty in achieving this goal is that the wafer to be exposed has been covered and separated by a thin layer of photosensitive resist. The thickness of the photosensitive resist layer is generally between 10 nm and 500 nm. The photosensitive resist layer makes the electron beam "invisible" to the pattern structure on the wafer below it, so that the electron beam cannot align the pattern on the wafer. Therefore, the typical method is that the mark used for alignment is the alignment mark **24** located outside the electron beam writing field. Aligning these marks requires the movement of the workbench, and in the case of open loop control of electron beam lithography, these alignments beyond the writing field are not directly aligned, that is, they are not aligned in situ. The movement of the stage introduces an error between the writing field **22** before the wafer movement and the writing field **22'** after the wafer movement.

Alignment error within one writing field

As mentioned above, the current electron beam lithography system requires alignment marks outside the writing field or even at the edge of the wafer. However, these alignment coordinate marks are not directly aligned (i.e., indirectly aligned), are not accurate, are not in-situ, and are time-consuming. The improved method is to set the alignment mark **13** within the writing field. However, a practical problem is still that if an alignment mark is set within the writing field, it will not be "seen" by the electron beam because it is covered by the photosensitive resist layer. Therefore, in the prior art, people would not think about or will not use the method of "setting alignment marks within the writing field".

Characterization of electron beam spot (FIG. **7**)

Using the uneven pattern (EIRC) on the surface of the electron beam photosensitive resist layer, the performance of the electron beam can also be characterized and calibrated in reverse:

a): Measurement of electron beam spot. The exposed uneven shape left by the electron beam on the surface of the photosensitive resist layer is exactly the shape of the electron beam spot.

b): The drift of the electron beam over time. The exposure concave-convex shape left by the electron beam on the surface of the photosensitive resist layer moves with time and can be measured by the contact sensor system. This drift can be used as a compensation correction for the electron beam writing field, but it is understood that no one has disclosed similar ideas in the prior art.

In summary, it can be seen that in the current photolithography technology, the surface of the wafer **1** to be processed (exposed) is coated with an opaque photosensitive resist layer **2**, so that the alignment coordinate mark must be located outside the writing field, especially in the outer edge of the entire wafer (that is, not in-situ) and away from the in-situ where the electron beam exposure is directly aligned, resulting in mechanical errors in the mechanical displacement of each writing field, errors in the stitching of each writing field pattern, and exposure errors caused by long-term drift of the electron beam caused by time-consuming. The resulting system error is not in-situ, "blind" open-loop control, so the error system cannot be compensated or repaired. As a result, the stitching errors in the prior art are very large and difficult to overcome, which is limited by the processing accuracy of the existing electromechanical system. The current lithography machine system accuracy is difficult to improve, and the price is high.

To overcome the above-mentioned defects in the prior art, the technical tasks that the disclosure needs to accomplish are:

1. Provide a sub-nano-level high-precision lithography writing field stitching method that is not limited to the electromechanical processing accuracy of the existing wafer workbench. It can accurately detect the exposure deviation of the writing field in real time, and perform lithography processing by automatic closed-loop control of the stitching correction;

2. Provide a lithography system for processing wafers by implementing the method;

3. Provide a pre-processed wafer implementing the above method;

4. Provide a method for measuring electron beam drift;

5. Provide a method for vertical stitching of sub-nano-level high-precision lithography writing fields.

The task of the disclosure is achieved through the following technical solutions:

1. Sub-nano-level high-precision lithography writing field stitching method comprises the following steps:

step 1: in the chamber of the lithography machine system, set the stage, the electron beam column and its electron gun, the wafer moving stage and at least one nano contact sensor; the wafer stage is equipped with a numerical control that controls its movement Drive device; before the wafer is put into the lithography system, the entire wafer is coated with a photosensitive resist layer. The scanning range of the electron beam is the exposure area, and the exposure area is divided into a plurality of writing fields, each on the photosensitive resist layer The writing field is provided with a specific in-situ alignment coordinate mark that will show a predetermined shape after exposure in the exposure area; the writing field is the first writing field, the second writing field, ..., the nth writing field;

step 2: place the wafer coated with photosensitive resist layer on the workbench, and make the first writing field of the wafer fall into the exposure area, make the electron beam column of the electron microscope face the exposure area vertically, and then make the electron beam focus on the writing field;

step 3: expose a part of the wafer on the first writing field in the exposure area, so that the photoresist coated on the part of the wafer undergoes a chemical reaction after exposure to cause electron beam-induced changes to produce at least one or a group of components with the concave-convex structure of the graphic. The specific shape of the concave-convex structure is used as the characteristic shape of the preset in-situ alignment coordinate mark, and the coordinate value of the characteristic point in the exposure area is used as the in-situ alignment coordinate;

step 4: Activate the nano-contact sensor to measure the surface shape of the concave-convex structure first, then identify the above-mentioned alignment coordinate mark against the preset specific shape, and then determine and memorize its coordinate value on the work surface;

step 5: Perform pre-exposure preparations for the second writing field. The moving workbench drives the wafer to move horizontally and/or vertically, so that the first writing field area that has just been exposed moves out of the exposure area to become the writing field **22-1'**, to make place so that the second writing field of the subsequent wafer enters the exposure area;

step 6: Start the nano contact sensor to recognize the alignment coordinate mark in the first writing field moved out of the exposure area, and determine and memorize the position coordinates of the first writing field on the workbench after the movement;

step 7: Using the data of the alignment coordinate mark in the first writing field after the movement as the basis of closed-loop feedback control, calculate the actual coordinate deviation before and after the movement of the writing field to determine the coordinate correction value of the entire exposure area of the next electron beam:

suppose that the coordinates of the second writing field after the error correction to be exposed adjacent to the first writing field that has moved out of the exposure area is C1R1', that is, the coordinates $(X_{C1R1'}, Y_{C1R1'})$. This is also the second writing field to be exposed. Stitch to the new coordinates of the first writing field after moving, namely:

$$(X_{C2L1'}, Y_{C2L1'}): X_{C2L1'}=X_{C1R1'}, Y_{C2L1'}=Y_{C1R1'};$$

the electron beam is now facing the second writing field in the exposure area. The coordinates of the second writing field before the error correction is C2L1, which is the coordinates $(X_{C2L1}, Y_{C2L1})$. Because this coordinate point needs to be applied to the electron beam by applying a deflection voltage to stick to the already moved The edge coordinates C1 R1' of the first writing field are used for stitching correction exposure to the coordinates of the second writing field, so that the relevant coordinate point of the second writing field after correction is C2L1', and the coordinate difference between C2L1' and C2L1 is:

$$\Delta X_1=X_{C2L1'}-X_{C2L1}=X_{C1R1'}-X_{C2L1}$$

$$\Delta Y_1=Y_{C2L1'}-Y_{C2L1}=Y_{C1R1'}-Y_{C2L1}$$

considering that the second writing field and the coordinates thereof cannot be obtained because the workbench does not move and the exposure is not carried out yet, the whole electron beam drift of the electron beam in the exposure area exposing the first writing field and the exposure area exposing the second writing field is neglected and disregarded, so that the coordinates before the exposure and before the correction of the second writing field in the exposure area are equal to the coordinates when the first writing field in the exposure area is exposed: $X_{C2L1}=X_{C1L1}$, $Y_{C2L1}=Y_{C1L1}$. And then the coordinate can be measured through a concave-convex structure formed by exposure on the surface of the photosensitive resist layer before the workbench moves after the first writing field is exposed, so that the coordinate difference of the second writing field with the electron beam coordinate to be corrected and to be compensated is obtained:

$$\Delta X_1 = X_{C1R1'} - X_{C1L1}$$

$$\Delta Y_1 = Y_{C1R1'} - Y_{C1L1};$$

step 8: Adjust the deflection voltage of the electron beam column according to the obtained coordinate difference that needs to be compensated, and correct the electron beam exposure area so that the stitching coordinate of the second writing field of the wafer that subsequently enters the exposure area is corrected to be the same as that of the moved The adjacent stitching coordinates of the first writing field, and the stitching coordinates of the corrected second writing field are seamlessly connected with the moved first writing field.

Further measures comprise the following steps:

step 9: Perform electron beam exposure on the part of the wafer in the second writing field that is moved to the exposure area after the electron beam exposure coordinate correction, so that the photoresist coated on the part of the wafer after exposure chemically reacts and reveal the preset alignment coordinate mark in the writing field characterized by a specific concave-convex structure;

step 10: Start the nano contact sensor to recognize the above-mentioned alignment coordinate mark against the preset specific shape, determine and memorize the position coordinates of the characteristic coordinate point in the corrected second writing field on the work surface;

step 11: Perform pre-exposure preparations for the third writing field, move the workbench again to drive the wafer to move horizontally and/or vertically, so that the first writing field that has been moved before and the corrected second writing field that has just been exposed are both Is moved to move the corrected second writing field that has just been exposed out of the exposure area, and the position of the first writing field that has been moved changes before the position of the first writing field that has been moved twice. The coordinates are changed from (C1Lx', C1Rx') to (C1Lx", C1Rx"), and the position coordinates of the second writing field moved out of the exposure area after correction are changed from (C2Lx', C2Rx') to (C2Lx", C2Rx"), The second writing field becomes the second writing field after the movement, to make place for the third writing field of the subsequent wafer to move into the exposure area;

step 12: Start the nano contact sensor again to recognize the alignment coordinate mark in the second writing field moved out of the exposure area, determine and memorize its position coordinates on the workbench (C2L1"; C2L2"; C2L3"; C2R1"; C2R2"; C2R3");

step 13: Taking the data of the alignment coordinate mark in the second writing field after the movement as the basis of closed-loop feedback control, the deviation of the actual coordinates before and after the movement is calculated to determine the correction value $\Delta X_2$ of the writing field of the next exposure area of the electron beam and $\Delta Y_2$:

suppose that the coordinates of the third writing field that is adjacent to the moved second writing field that has moved out of the exposure area and is about to be exposed are C2R1", that is, coordinates $(X_{C2R1''}, Y_{C2R1''})$. This is also the third writing field to be exposed. The stitches are stitched to the corrected coordinates of the moved second writing field, namely:

$$(X_{C3L1''}, Y_{C3L1''}): X_{C3L1''}=X_{C2R1''}, Y_{C3L1''}=Y_{C2R1''};$$

the coordinates of the electron beam facing the third writing field located in the exposure area at this time are C3L1, that is, coordinates $(X_{CSL1}, Y_{C3L1})$, and the coordinate difference between it and the second writing field that has been moved to follow the stitching exposure is this coordinate point. The electron beam is applied with a deflection voltage to stick to the edge of the second writing field C2R1" that has been moved for stitching exposure. The corrected coordinate point of the third writing field is C3L1", and the coordinate difference between C3L1" and C3L1' is:

$$\Delta X_2=X_{C3L1''}-X_{C3L1'}=X_{C2R1''}-X_{C3L1'}$$

$$\Delta Y_2=Y_{C3L1''}-Y_{C3L1'}=Y_{C2R1''}-Y_{C3L1'};$$

the overall electron beam drift of the second writing field and the third writing field exposed by the electron beam in the exposure area is ignored, so that the coordinates of the third writing field before the exposure coordinate correction in the exposure area are equal to the second writing field coordinates during exposure: $X_{C3L1'}=X_{C2L1'}$, $Y_{C3L1'}=Y_{C2L1'}$, so that the coordinates can be measured by the concave-convex structure formed by the exposure on the surface of the photosensitive resist layer after the second writing field is exposed and the workbench moves to obtain all writing The coordinate difference to be compensated for the electron beam coordinate correction of the field exposure point:

$$\Delta X_2=X_{C2R1''}-X_{C2L1'}$$

$$\Delta Y_2=Y_{C2R1''}-Y_{C2L1'};$$

step 14: Adjust the deflection voltage of the electron beam column (32) according to the obtained correction value, and correct the electron beam exposure area so that the coordinates of all exposure points in the third writing field of the subsequent wafer are corrected to be the same as the second shifted The stitching coordinates of adjacent writing fields are consistent and seamless;

step 15: Repeatedly, complete the exposure, movement and stitching of the entire writing field area of the entire wafer.

Furthermore:
the electron beam may also be an ion beam, a photon beam or an atomic beam.
The nano contact sensor is one or a combination of one or more of an atomic force tip sensor, a tunnel electron probe sensor, or a nano-level surface work function measurement sensor.
The wafer comprises the entire complete wafer, part of the wafer, or non-wafer materials that need to be stitched by the lithography writing field.
The in-situ alignment coordinate mark is a graphic mark of a plane structure.
There are 1, 2, 3, 4, 5, 6 or more of the graphic marks of the plane structure on a plane.
The planar structure graphic mark comprises a graphic mark formed by a slight geometric structure change caused by the surface of the photoresist layer induced by an electron beam.
The in-situ alignment coordinate mark is a three-dimensional shape mark.
The three-dimensional shape identifier is pyramid-shaped or cone-shaped, and the identifier is provided with 1, 2, 3, 4, 5, 6, or more on a plane.
There are 1, 2, 3 or 4 or more nano contact sensors, which are distributed around the exposure area.
The nano-contact sensor is provided with a lever-type sensing contact arm, and one or more needle-point sensing contacts arranged in rows are provided on the contact arm.
The electron beam is a Gaussian beam.
The electron beam is a Variable Shaped Beam.
2. A sub-nano-level high-precision writing field stitching lithography machine system comprises a stationary chamber and a stage in the chamber. Above the stage is an electron microscope, at least one nano-contact sensor and a wafer moving stage; an electron beam column is arranged on the upper; the wafer workbench is provided with a numerical control driving device for dragging the front, back, and/or left, right, and/or up, down movements and angle changes.

The lithography machine system also comprises a control computer, which is connected to a pattern generator, an electron beam control system, and a numerical control driving device of the wafer workbench, and the nano contact sensor collects the measured wafer. The in-situ alignment coordinate identification signal and/or the electron beam drift signal on the control computer are sent to the pattern generator under the control of the control computer, and the pattern generator sends the corrected electron beam scanning control signal after the arithmetic processing under the control of the control computer. The electron beam control system controls the shutter of the focusing system on the electron beam column and the deflection coil that controls the deflection of the electron beam.

The technical solutions for further consideration comprise:
The electron beam column is also provided with a secondary electron imaging signal collecting device, which feeds the collected secondary image scanned by the electron beam to the control computer through the electron beam control system.

The nano-contact sensor is one or a combination of one or more of an atomic force tip sensor, a tunnel electron probe sensor, or a nano-scale surface work function measurement sensor.

The nano contact sensor is provided with a lever-type sensing contact arm, and the contact arm is provided with a needle tip sensing contact.

Each contact arm is provided with one or more needle tip sensing contacts.

Each contact arm is provided with at least one row of needle tip sensing contacts, and each row is provided with more than one needle tip sensing contacts.

The nano contact sensor is provided with 2 rows, each row is provided with 4, and the 2 rows are arranged on both sides of the electron beam column.

The electron beam column is directly facing the exposure area of the wafer on the workbench.

3. A pre-processed wafer, on which a photosensitive resist layer to be exposed is coated, and a portion of the writing field area of the wafer and/or its photosensitive resist layer is partially provided with electron beam exposure. A convex in-situ alignment coordinate mark with a specific shape is provided for the nano-contact sensor to recognize the in-situ coordinate.

The in-situ alignment coordinate mark is a graphic mark of a plane structure.

There are 1, 2, 3, 4, 5, 6 or more graphic marks of the plane structure on a plane.

The graphic mark of the planar structure is a graphic mark formed by an electron beam inducing a slight geometric structure change on the surface of the photoresist layer.

The in-situ alignment coordinate mark is a three-dimensional shape mark.

There are 1, 2, 3, 4, 5, 6 or more three-dimensional marks on a plane.

The wafer comprises the entire complete wafer, part of the wafer, or non-wafer materials that need to be stitched by the lithography writing field.

4. Provide a method for measuring electron beam drift, comprising the following steps. In the chamber of the lithography machine system, first set up the stage, the electron beam column and its electron gun, the wafer moving stage and the nano-contact sensor; A numerical control driving device to control its movement is set on the circular workbench, and a photosensitive resist layer is coated on the wafer, and then the electron gun is used to emit an electron beam to focus the light on the photosensitive resist layer and expose it, to produce small changes in the geometric shape of the concave-convex structure on the surface induced by the electron beam. The small changes are measured and the drift of the focus point over time is tracked, and then the coordinate value and drift amount of the drift track of the electron beam over time are recorded.

The method further comprises the following steps: calculating exposure coordinate values and correction compensation differences generated by the drift of the electron beams along with time in the initial and final interval time periods according to the recorded coordinate values and drift amount of the drift tracks of the electron beams along with time, and obtaining correction coordinates of the next writing field exposure.

5. Provide a method for vertical stitching of sub-nano-level high-precision lithography writing fields. Firstly, a three-dimensional wafer alignment mark with a convex structure is preset on the wafer to be lithographically processed, and then a photosensitive resist is coated on it Layer, so that the photosensitive resist layer with the corresponding protruding structure is also generated at the position where the three-dimensional alignment mark is preset, and then the wafer with the three-dimensional alignment mark is moved to the electron beam through the wafer stage In the exposed writing field area, the electron beam is aligned to the position of the three-dimensional alignment mark of the photosensitive resist layer to perform spot exposure, and actual deviation three-dimensional marks are generated outside the exposure point of the photosensitive resist layer, and then the nano-contact sensor photosensitive resist is used layer-by-layer measurement of the actual coordinate values of the three-dimensional alignment mark and the deviated three-dimensional mark, and then calculate the correction value of the exposure area of the writing field, thereby controlling the electron gun to achieve vertical precision alignment and exposure, and realize vertical precision stitching.

After using the lithography system of the technical solution of the disclosure to expose the wafer in the writing field portion of the exposure area with electron beams, the wafer in the writing field portion will reveal the original shape composed of concave and/or convex. The position is aligned with the coordinate mark, and the nano-contact sensor on the lithography machine system can identify the in-situ coordinates on the wafer in the exposure area of the writing field and record it. When the wafer moves the writing field (for example, a first writing field) out of the exposure area along with the transverse, longitudinal or compound movement of the wafer workbench, the actual coordinates of the wafer of the writing field part after being moved out can be re-identified and recorded by the nano-contact sensor, and a computer system on a lithography system can compare errors caused by the workbench movement and electron beam drift, so that the exposure area error correction parameter of the next writing field (for example, a second writing field) is worked out, and the wafer part of the writing field (the second writing field) is exposed to the writing field by the electron beam after being corrected by the exposure coordinates. In this way, the additional offset corrected by the electron beam in the second writing field is attached to the writing field (first writing field) that was moved out of the exposure area last time for precise stitching. After the second writing field is exposed, the wafer workbench moves to move the second writing field of the wafer out of the writing field exposure area. Repeatedly, the wafer is moved again and again, so that the wafer part of each write field after each exposure can realize the closed-loop control splicing of horizontal and/or sub-time error correction, so as to achieve the stitching of the writing field in sub-nanometer precision, instead of demanding the further improvement of the electromechanical machining accuracy of the workbench of the lithography system, even if the current common and cheap lithography system is used in conjunction with the nano contact sensor detection technology of the disclosure, the in-situ alignment coordinate mark detection, the closed-loop stitching control technology composed of "sight-seeing people" can also realize high-precision lithography stitching of sub-nanometer wafers. In addition, the lithography system of the disclosure has low manufacturing cost and low producing cost, which is a pioneering improvement to the prior art.

The disclosure will be further described below with reference to the drawings and embodiments. Of course, these embodiments are only schematic and general descriptions for the purpose of explaining each claim, but they should not be interpreted as being limited to these embodiments.

FIGS. **1A** and **1B** are schematic diagrams of electron beam lithography;

Among them: **1**-wafer (substrate); **2**-photosensitive resist layer; **3**-pattern produced after electron beam exposure (take grating as an example); **4**-electron beam emitted by electron gun in the electron beam column; **5**-just exposed Position of the electron beam coordinates (CPJE); **6**-No exposure but aiming at the coordinates of the electron beam to be exposed.

FIGS. **2A-2B** are schematic diagrams of two principles of using electron beam-induced photoresist layer modification (EIRC) in the disclosure to expand or shrink on the sub-nanometer or nanometer scale to form a concave-convex structure.

Among them: **1**-wafer (substrate); **2**-photosensitive resist layer; **7**-electron beam unexposed photosensitive resist layer; **8**-electron beam exposed photosensitive resist layer EIRC (concave shrinkage); **10**-electron The EIRC of the light-sensitive resist layer that has been exposed by the beam (produces convex expansion); **9**, **11** are the height-direction concave contraction and convex expansion scales, usually on the order of sub-nanometer to several nanometers.

FIG. 3 is a schematic diagram of the locations of three types of alignment marks;

Among them: **1**-wafer; **12**-long-distance out-of-field mark (RA1); **13**-in-field mark (IA); **14**-out-of-field mark (RA2) located between writing fields; **15**-writing field; **16**-rotation Angle, $\times$ and Y are rectangular coordinate systems. The wafer moves in the XYZ direction or XY, YZ, XZ plane through the workbench.

The mark **12** far away from the writing field and the mark **14** between writing fields in the traditional technology are both outside the writing field: it is a long-distance alignment mark (RA mark), which can only allow the electron beam to radiate by moving the workbench away from the writing field.

The in-field mark is used in the disclosure. It is an in-field mark (IA mark), which can be radiated in the writing field without moving the wafer stage. If the in-field mark is placed exactly on or very close to the photoresist layer/wafer under the electron beam mark (CPJE, CPTE), it can be used as an in-situ alignment mark (ISA). If these two coordinates coincide, this in-situ alignment mark constitutes an overlapped alignment mark (OA mark).

FIG. **4** is a schematic diagram of the principle of another uneven structure of the disclosure;

Among them: **1**-wafer; **2**-photosensitive resist layer; **392**-contact of nano-contact sensor **39**; **18**-photosensitive resist layer three-dimensional protrusion alignment mark (HAMR); **19**-preset three-dimensional convexity on the wafer surface Out alignment mark (HAMW); **20**-the height of the preset three-dimensional protruding mark on the surface of the wafer, located under the photosensitive resist layer **2**; **21**-the height of the three-dimensional protruding mark on the photosensitive resist layer **2**, which is determined by the wafer **1**. The three-dimensional protruding mark of the photosensitive resist layer caused by the transfer of the preset three-dimensional protruding mark on the surface can be detected by the contact **392** of the nano-contact sensor **39** for the uneven structure.

FIGS. **5A-5C** are schematic diagrams of the process in which there is a huge stitching error between the writing fields of the previous writing field and the writing field of the next writing field in the prior art;

In FIG. **5A**: **22-** is the first writing field, the wafer in the writing field is at the exposure position; **23-** is the grating (taking the grating as the exposure pattern as an example); **24-** is the alignment mark far away from the writing field;

The figure shows the first writing field **22** that enters the exposure area and waits for electron beam exposure.

In FIG. **5B**: **22'**-is the first writing field moved out of the exposure area; **22-** is the second writing field position moved into the exposure area subsequently; **27-** is the actual moving direction of the workbench **38**; **28-** is the planned moving direction of the workbench **38**;

In the figure, the workbench **38** moves to move the first writing field out of the range of the writing field irradiated by the electron beam, freeing up the electron beam exposure space for the next writing field, that is, the second writing field. The mechanical error of the moving of the workbench **38** will cause stitching errors.

In FIG. **5C**: **29X** is the horizontal (X direction) stitching error caused by the movement of the workbench **38**, and **29Y** is the vertical (Y direction) stitching error caused by the movement of the workbench **38**.

FIG. **6A** is a schematic diagram of the prior art when the wafer has not been moved out of the original position after being exposed in the first writing field **22** of the exposure area;

FIG. **6B** is a schematic diagram of the wafer being placed in the first writing field **22** of the exposure area, the wafer is removed for other processing and then placed in the workbench exposure area for photolithography or for the second exposure. Due to the error caused by the movement of the stage, the new position **22'** of the first writing field is deviated. At this time, the writing field in the electron beam exposure area is the second writing field, that is, the original writing field position **22**. The writing field **22'** does not coincide with the second writing field, resulting in a vertical alignment error.

FIGS. **7A-7B** are schematic diagrams of describing and characterizing the electron beam by electron beam induced modification of the photosensitive layer **2** (EIRC);

In FIG. **7A**: **1**-wafer; **2**-photosensitive resist layer; **17**-electron beam; **29**-exposure point of photosensitive resist layer **2** exposed electron beam focus point;

In FIG. **7B**: 1-wafer; **2**-photosensitive resist layer; **17**-electron beam; **17'**-the position of the electron beam drifted with time; **30**-the exposed spot of the photosensitive resist layer **2** reveals the focus of the electron beam irradiation after the drift.

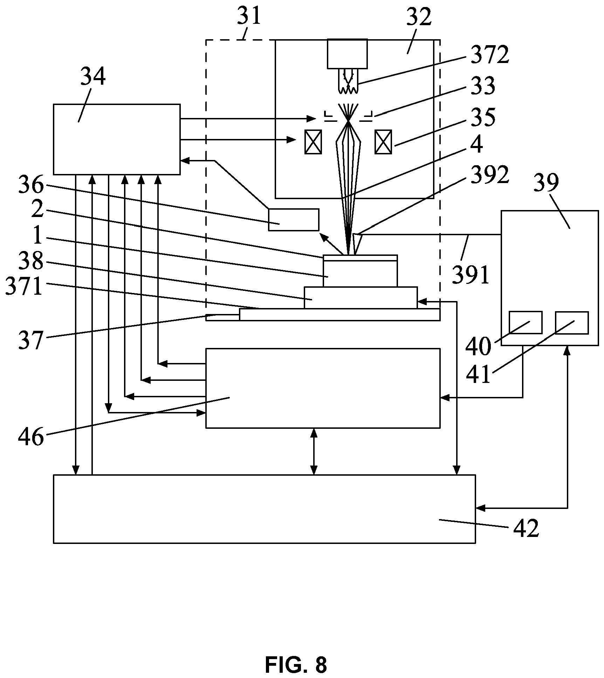

FIG. **8** is a schematic diagram of the composition of the sub-nano-level high-precision writing field stitching lithography machine system of the disclosure;

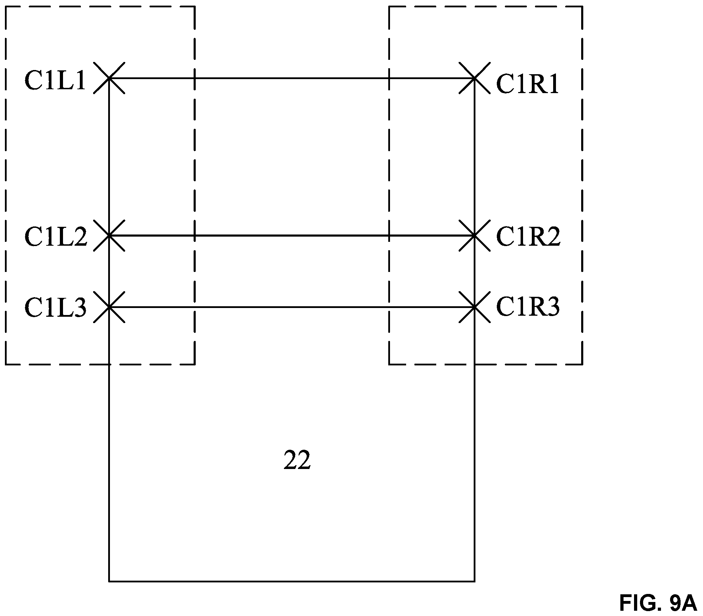

FIGS. **9A** - **9F** are schematic diagrams of the stitching alignment method illustrated by the disclosure taking horizontal stitching as an example;

FIG. **9A** shows the position coordinates of 6 in-situ alignment markers measured by the nano contact sensor after the wafer in the first writing field **22-1** has been exposed after exposure (for example): C1L1, C1L2, C1L3 and C1R1 C1R2, C1R3. Among them: C1 represents the first writing field, Lx represents the left coordinate of the writing field; Rx represents the right coordinate of the writing field.

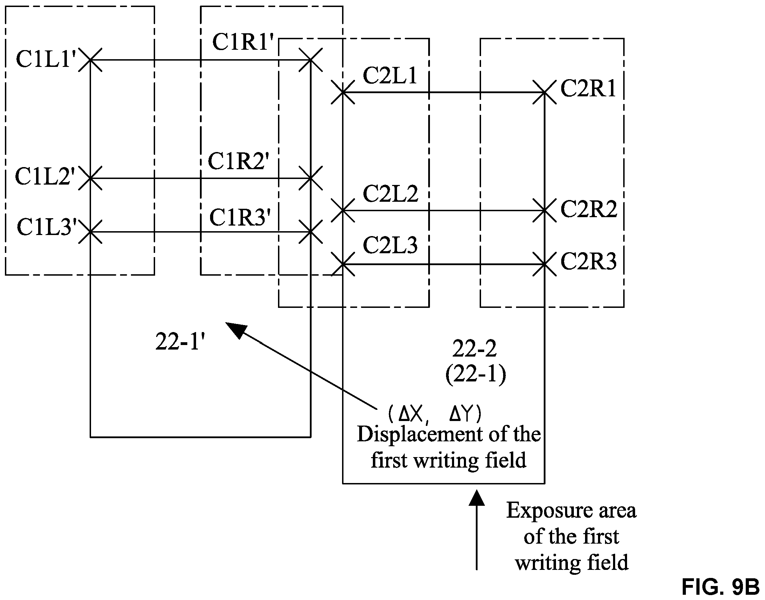

FIG. **9B** shows the position coordinates of the above-mentioned in-situ alignment coordinate mark after the movement is measured by the nano-contact sensor after the wafer in the first writing field **22-1** is exposed and moved out of the exposure area **22** to become the writing field **22-1'**: C1L1'-L3' and C1R1'-R3', and the next writing field moved into the exposure area 22 is the second writing field (writing field **22-2**); the electron beam scanning exposure area is still **22-1**, which is the current writing field **22-2**.

The wafer workbench moves, and then the second writing field cannot be exposed at this position due to stitching errors. Its coordinates are C2L1-L3 and C2R1-R3; after the workbench moves, the graphics related to the writing field 22-1' are moved to the left of the second writing field that will be subjected to subsequent exposure, the corresponding coordinates measured by the nano contact sensor after moving are: C1L1'-L3' and C1R1'-R3';

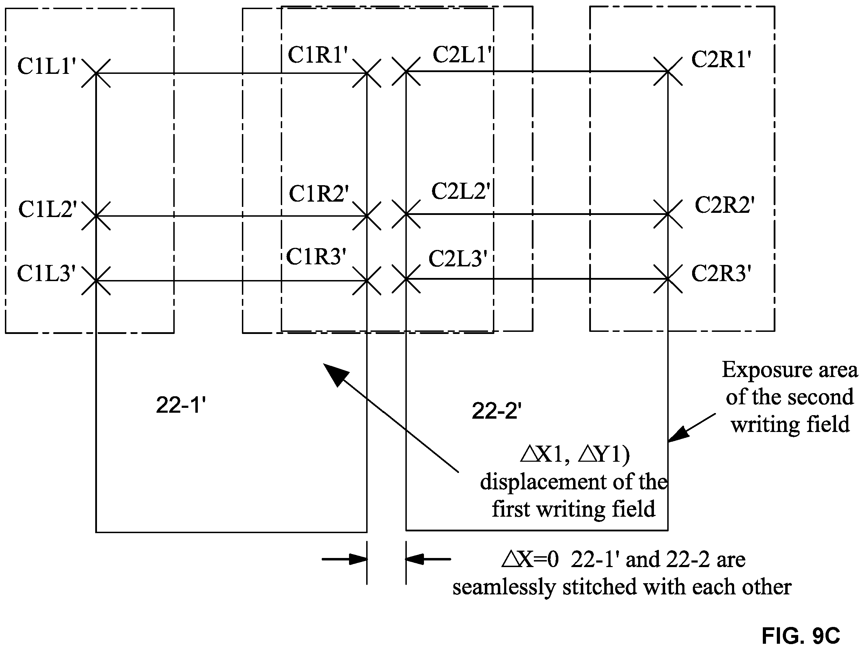

FIG. **9C** is calculated based on the comparison of the measured coordinate values of the first writing field **22-1** after exposure and moving out of the exposure area to become the writing field **22-1'** with the measured coordinate values of the first writing field **22-1** that have not moved out of the exposure area after exposure The error correction value negative feedback adjustment and correction of the writing field of the actual exposure area becomes the position schematic diagram of the corrected second writing field **22-2'**;

The coordinates of the corrected second writing field **22-2'** are: C2L1', C2L2', C2L3' and C2R1', C2R2', C2R3', and: C2L1' is the same as C1R1', C2L2' is the same as C1R2', C2L3' is the same as C1R3', that is, the corrected second writing field **22-2'** and the writing field **22-1'** achieve precise stitching.

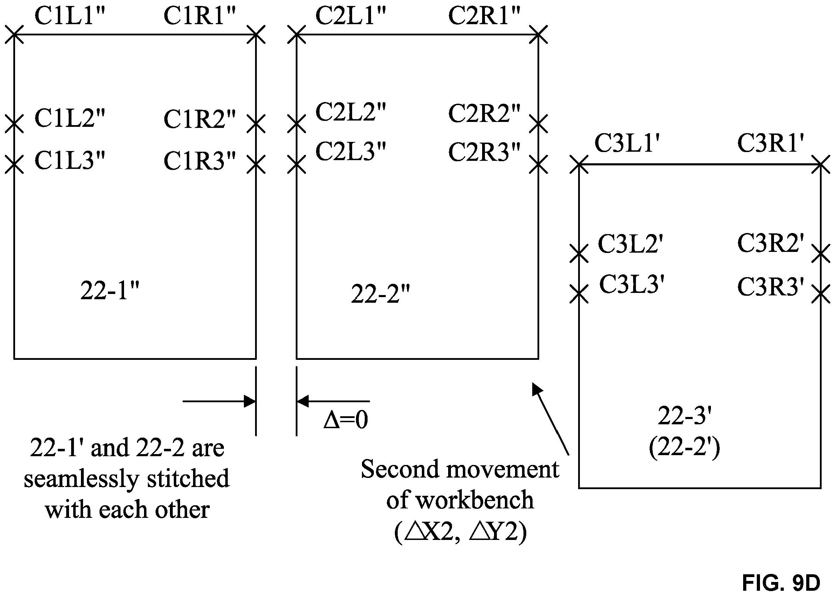

FIG. **9D**: The workbench moves for the first time, and the second writing field is seamlessly stitched with the first writing field. At this time, the workbench moves a second time, freeing up a new exposure area space **22-3'**. At this time, the coordinates of the first writing field become C1Lx", C1Rx" due to the second movement of the workbench, and the coordinates of the second writing field become C2Lx", C2Rx" due to the second movement of the workbench. The corresponding coordinates of **22-3'** are C3Lx', C3Rx'. The electron beam exposure area still stays at the corrected second writing field **22-2'**.

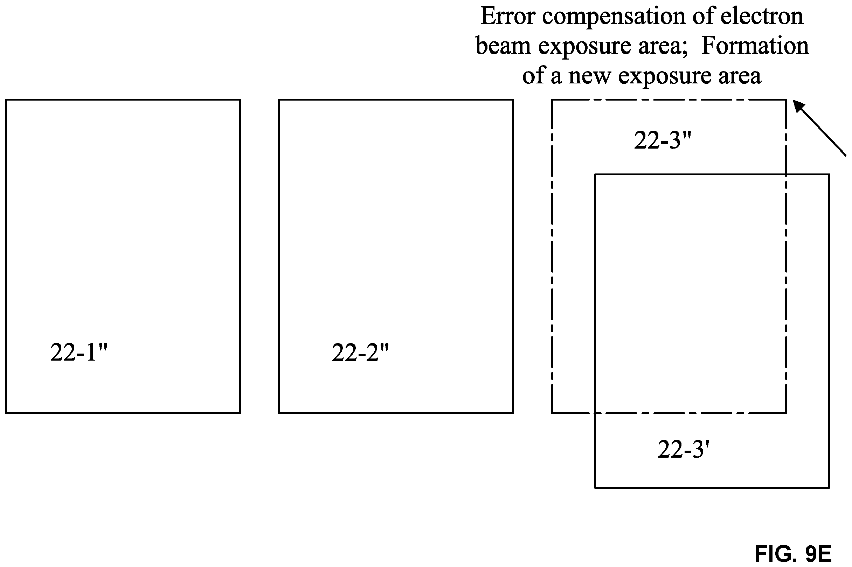

FIG. 9E: The electron beam obtains the coordinate deviation value of the exposure third writing field, and through the electron beam coordinate compensation, the exposure area is moved to be close to the second writing field **22-2"**. Then the third writing field exposure is performed.

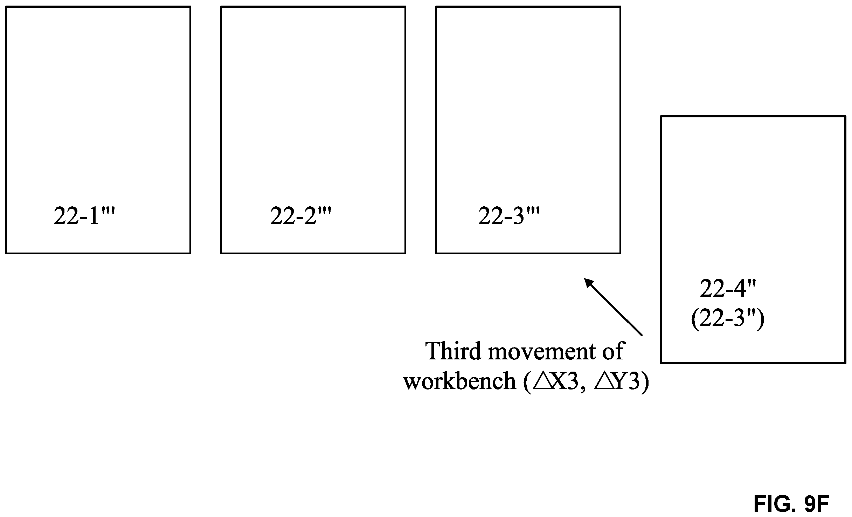

FIG. 9F: The third movement of the workbench. The first writing field **22-1"** moves to become **22-1'''**, the second writing field **22-2"** moves to become **22-2'''**, and the third writing field **22-3"** moves to become **22-3'''**. Free up the exposure space **22-4"** (at the **22-3"** position).

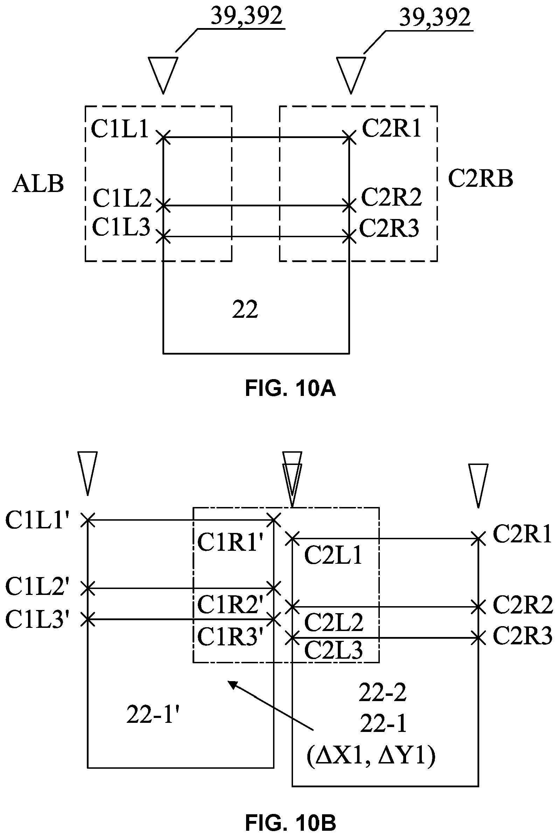

FIGS. **10A** and **10B** are schematic diagrams of using two nano-contact sensors to measure in-situ coordinate marks to achieve stitching and alignment, so as to achieve faster measurement speed.

The contacts **392** of the two sets of nano-contact sensors **39** in FIG. **10a** are placed on both sides of the writing field **22**, which facilitates the wafer to move to the left or stitched to the right through the workbench. At this time, the writing field **22** has been exposed but has not moved out of the exposure area, the contacts **392** of the two sets of nano-contact sensors performs measurement to the in-situ align coordinate marks C1L1, C1L2, C1L3 and C1R1, C1R2, C1R3 preset on the writing field **22**; each group of nano-contact sensors **39** contains three longitudinal contacts **392** for example.

FIG. **10B** is a schematic diagram showing a process in which two sets of nano-tip sensors are moved to both sides of the writing field **22-1'**, and in-situ alignment coordinate markers C1L1', C1L2', C1L 3', C1R1 ', C1R2' and C1R3'on a wafer moved out of the exposure area after exposure and located at the position of the writing field **22-1'** are measured, so as to calculate an error correction value for a subsequently entered wafer of the writing field **22-2**, and adjust exposure deflection parameters and a focus of an electron gun in a lens column of an electron microscope, so that the corrected stitching coordinates of the writing field **22-2** 'are precisely matched with the writing field **22-1'**.

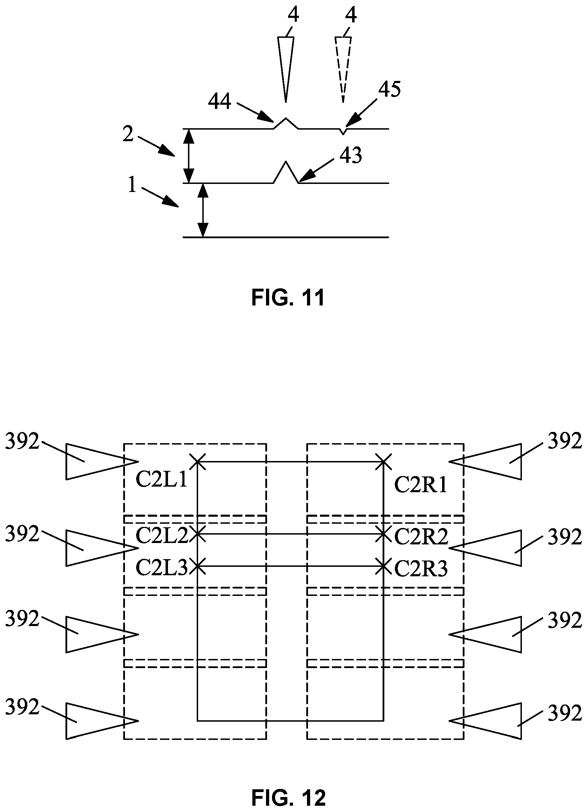

FIG. **11** is a schematic diagram of a method for realizing vertical layer alignment and stitching by using preset three-dimensional protruding structures **43** on the wafer and the photosensitive resist layer and the three-dimensional structure **44** of the photosensitive resist layer as three-dimensional in-situ alignment coordinate marks, and schematic diagram of the method of aligning and stitching the vertical layer by measuring the offset exposure error using electron beam **4**.

Firstly, pre-position the protruding structure of the wafer three-dimensional alignment mark **43** on the wafer to be processed by photolithography, and then coat the photo-sensitive resist layer on it, so that the three-dimensional alignment mark is also generated at the position where the three-dimensional alignment mark is preset. The three-dimensional alignment mark **44** of the photosensitive resist layer corresponding to the protruding structure.

Move the wafer with the three-dimensional alignment mark through the wafer stage **38** into the writing field area where the electron beam can be exposed, and align the electron beam to the three-dimensional alignment mark **44** (position 1) of the photosensitive resist layer for spot exposure. A three-dimensional mark **45** (position 2) that may be deviated is generated on the exposure point of the resist layer. Using the nano contact sensor to measure position 1 and position 2 can calculate the correction value of the exposure area of the writing field, thereby controlling the electron gun to achieve precise vertical alignment and exposure, thereby achieving precise stitching.

FIG. **12** is a schematic diagram of the rapid stitching and alignment of nano-contact sensors with multiple nano-contacts on each nano-contact sensor.

The sensing arm of the nano-contact sensor **39** is provided with 2 rows, each with 4 nano-contacts.

Referring to FIGS. **1A-1B** and 8, a sub-nano-level high-precision writing field stitching lithography machine system is constructed, which comprises a sealed, statically placed electron microscope chamber **31**, a stage **37** in the chamber **31**, an electron beam column **32**, and at least one nano-contact sensor **39** and a wafer workbench **38**; an electron beam column **32**, an electron emission gun **372**, a focusing system **33**, a deflection coil **35**, etc. are provided on the electron microscope. The wafer workbench **38** is provided with a numerical control driving device **371** for dragging it forward, backward, left, right and/or up and down, and angle changes.

The control computer **42** is connected to the electron beam column and the nano contact sensor **39** via an electron beam control system **34** and a pattern generator **46**. The nano contact sensor **39** aligns the collected in-situ coordinate identification signals on the measured wafer **40** and/or the electron beam drift signal **40** is sent to the pattern generator **46** under the control of the control computer **42**, and the pattern generator **46** sends the corrected electron beam scanning control signal after calculation and processing to the electron beam control under the control of the control computer **42** System **34**. The electron beam control system **34** controls the shutter of the focusing system **33** on the electron beam column **32** and the deflection coil **35** that controls the deflection of the electron beam. In view of the fact that the structure and working principle of the electron microscope and the nano contact sensor are well known, the electron microscope and the nano contact sensor will not be described in more depth here.

The electron beam column **32** may further comprise a secondary electron image signal collecting device **36** for feeding back the collected secondary image scanned by the electron beam to the control computer **42** through the electron beam control system **34** for video display.

The nano-contact sensor **39** has sub-nano-level measurement accuracy, and can use any one or more of an atomic force tip sensor, a tunnel electron probe sensor, or a nano-level surface work function measurement sensor. The nano-contact sensor **39** is installed in the sample cavity of the electron beam lithography system, and can measure the three-dimensional surface topography with sub-nanometer accuracy and good spatial repeatability. The nano-contact sensor is located beside the electron beam column **32**, near the focus point of the electron beam and above the surface of the photosensitive resist layer.

The nano contact sensor **39** is provided with a lever-type sensing contact arm **391**, and the contact arm **391** is provided with a needle tip sensing contact **392**, as shown in FIG 8.

Each contact arm **391** is provided with at least one row of needle tip sensing contacts **392**, and each row is provided with more than one needle tip sensing contacts **392**.

Taking FIGS. **10A-10B** as an example, there are two rows of needle tip sensing contacts **392**, each row is provided with one needle tip sensing contact **392**, and the two rows are arranged on both sides of the electron beam column **372**.

FIG. **12** is an example, in which there are two rows of needle tip sensing contacts **392**, and each row is provided with **4** needle tip sensing contacts **392**.

The electron beam column **32** is facing the exposure area **22** of the wafer on the wafer stage **38**.

At the beginning of the implementation of the method of the disclosure, the wafer needs to be pre-processed, that is, the photosensitive resist layer **2** to be exposed is coated on the wafer **1**, and part of the writing field area of the wafer **1** and/or the photosensitive resist layer **2** is provided After electron beam exposure, it can reveal the in-situ alignment coordinate mark **8**, the in-situ alignment coordinate mark **10**, the in-situ alignment, which is composed of concave and/or convex and has a specific shape for the nano contact sensor **39** to recognize the in-situ coordinates. The coordinate mark **44** or the coordinate mark **45** is aligned in situ.

This in-situ alignment coordinate mark can be a graphic mark of a plane structure, and 1, 2, 3, 4, 5, 6 or more can be arranged on a plane, and of course there can be more. In this embodiment, it is preferable to use an electron beam to induce the surface of the photoresist layer to produce a small geometric structure change to form a graphic mark. It is also possible to use other well-known technologies to form a similar effect.

The in-situ alignment coordinate marks can also be made into three-dimensional marks, and 1, 2, 3, 4, 5, 6 or more can be arranged on a plane, of course, there can be more. The three-dimensional shape mark is preferably made into a pyramid-shaped or cone-shaped three-dimensional shape for easy electronic identification, and other shapes are also possible.

After constructing the above working environment, the sub-nano-level high-precision lithography writing field stitching method of the disclosure can be implemented, and the steps involved are as follows:

Step 1: In the chamber **31** of the lithography machine system, set the stage **37**, the electron microscope and its electron beam column **32**, the electron gun **372**, the wafer moving stage **38** and at least one nano-contact sensor **39**; wafer work The stage **38** is equipped with a numerical control driving device **371** that controls its movement; before the wafer is put into the lithography system, the entire wafer **1** is coated with a photosensitive resist layer **2**, and the electron beam scanning range is the exposure area **22**, the exposure area is divided into a plurality of writing fields, and each writing field on the photosensitive resist layer is provided with a specific in-situ alignment coordinate mark **8**, which will reveal a predetermined shape after exposure in the exposure area, an in-situ alignment coordinate mark **10**. Position alignment coordinate mark **18**, in-situ alignment coordinate mark **43**, in-situ alignment coordinate mark **44**; the writing fields are the first writing field **22-1**, the second writing field **22-2**, ... the nth writing field **22-n**. For example, if there are 1000 writing fields, then n is 1000, and the wafers with 1000 writing fields need to be exposed and stitched.

Step 2: Place the wafer **1** coated with the photosensitive resist layer **2** on the workbench **38**, and make the first writing field **22-1** of the wafer fall into the exposure area **22**, so that the electron beam column **32** of the electron microscope is vertical for the exposure area **22**, the electron beam is then focused on the writing field. The first writing field **22-1** refers to the first writing field, the second writing field **22-2** refers to the second writing field, and the third writing field refers to the third writing field. "'" of "**22-1**'" means that the workbench has moved once. "''" of "**22-1**''" means that the work stage has moved twice, that is, "**22-1**''" means the first writing field and the work stage has moved the first writing field twice, and so on.

Step 3: Expose a part of the wafer on the first writing field **22-1** in the exposure area **22**, so that the photosensitive glue coated on the part of the wafer undergoes a chemical reaction after exposure to cause electron beam-induced changes to produce at least one or a group of concave-convex structures forming a pattern, the specific shape of the concave-convex structure is used as the feature shape of the preset in-situ alignment coordinate mark, and the coordinate value of the feature point in the exposure area is taken as the in-situ alignment coordinate.

Step 4: Enable the nano contact sensor (**39**) to measure the surface shape of the concave-convex structure first, then identify the above-mentioned alignment coordinate mark against the preset specific shape, and then determine and memorize its coordinate value on the work surface, for example: (C1L1; C1L2; C1L3; C1R1; C1R2; C1R3). In principle, more than one of these coordinate points can be selected in the writing field (the same below).

Step 5: Pre-exposure preparation for the second writing field. The moving stage **38** drives the wafer **1** to move laterally and/or longitudinally, so that the first writing field area **22-1** that has just been exposed moves out of the exposure area to become the writing field **22-1'**, to make place for the second writing field **22-2** of the subsequent wafer to enter the exposure area.

Step 6: Start the nano contact sensor **39** to recognize the alignment coordinate mark in the first writing field **22-1'** moved out of the exposure area, and determine and memorize the first writing field position coordinate (C1L1'; C1L2'; C1L3'; C1R1'; C1R2'; C1R3').

Step 7: Taking the data of the alignment coordinate mark in the first writing field **22-1'** after the movement as the basis for closed-loop feedback control, calculate the actual coordinate deviation before and after the writing field movement to determine the entire exposure area of the next electron beam coordinate correction value;

Suppose the first writing field **22-1'** that has moved out of the exposure area is adjacent to the second writing field **22-2'** to be exposed and the coordinates of the second writing field **22-2'** after error correction is **C1R1'**, that is, the coordinates $X_{C1R1'}$, $Y_{C1R1'}$, this is also about to be exposed The second writing field **22-2'** needs to be seamlessly stitched to the new coordinates of the moved first writing field **22-1'**, namely:

$$(X_{C2L1'}, Y_{C2L1'}): X_{C2L1'} = X_{C1R1'}, Y_{C2L1'} = Y_{C1R1'};$$

The electron beam is now facing the second writing field **22-2** in the exposure area **22**. The coordinates of the second writing field **22-2** before the error correction is C2L1, that is, the coordinates $(X_{C2L1}, Y_{C2L1})$, because this coordinate point needs to be attached by applying a deflection voltage to the electron beam. Use the edge coordinates C1R1' of the first writing field **22-1'** that have been moved to perform stitching correction exposure to the coordinates of the second writing field **22-2**, so that the corrected second writing field related coordinate points are C2L1', C2L1' and The coordinate difference of C2L1 is:

$$\Delta X_1 = X_{C2L1'} - X_{C2L1} = X_{C1R1'} - X_{C2L1}$$

$$\Delta Y_1 = Y_{C2L1'} - Y_{C2L1} = Y_{C1R1'} - Y_{C2L1}$$

In view of the second writing field and its coordinates $X_{C2L1}$, $Y_{C2L1}$ is not available because the workbench has not moved and has not been exposed. First, the electron beam is exposed to the exposure area of the first writing field and the entire electron of the exposure area of the second writing field. The beam drift is ignored, so that the coordinates of the second writing field **22-2** in the exposure area before exposure and before the correction are equal to the coordinates of the first writing field **22-1** in the exposure area: $X_{C2L1} = X_{C1L1}$, $Y_{C2L1} = Y_{C1L1}$, and then The coordinates can be measured by the concave-convex structure formed by the surface of the photosensitive resist layer before the workbench moves after the exposure in the first writing field, so as to obtain the coordinate difference that needs to be compensated for all the electron beam coordinate points in the second writing field:

$$\Delta X_1 = X_{C1R1'} - X_{C1L1}$$

$$\Delta Y_1 = Y_{C1R1'} - Y_{C1L1}.$$

Step 8: Adjust the deflection voltage of the electron beam column **32** according to the obtained coordinate difference $(\Delta X_1, \Delta Y_1)$ that needs to be compensated, and correct the electron beam exposure area to subsequently enter the second writing field **22-2** of the wafer in the exposure area The stitching coordinates (C2L1; C2L2; C2L3; C2R1;

C2R2; C2R3;) are corrected to the adjacent stitching coordinates (C2L1'; C2L2'; C2L3'; C2R1'; C2R2'; C2R3';), the stitched coordinates of the corrected second writing field **22-2'** are seamlessly connected to the moved first writing field.

Step 9: Perform electron beam exposure on the part of the wafer in the second writing field **22-2'** that is moved to the exposure area corrected by the electron beam exposure coordinates, so that the exposed part of the wafer is coated with photosensitive The glue chemically reacts to reveal the preset alignment coordinate mark in the writing field characterized by a specific concave-convex structure.

Step 10: Start the nano contact sensor **39** to identify the above-mentioned alignment coordinate mark against the preset specific shape, determine and memorize the position coordinates of the characteristic coordinate points in the corrected second writing field **22-2'** on the work surface (C2L1'; C2L2'; C2L3'; C2R1'; C2R2'; C2R3').

Step 11: Perform pre-exposure preparations for the third writing field, move the workbench **38** again to drive the wafer **1** to move laterally and/or longitudinally, so that the previously moved first writing field **22-1'** and the corrected post-exposure The second writing field **22-2'** is moved so that the corrected second writing field that has just been exposed is moved out of the exposure area, and the position coordinates of the previously moved first writing field **22-1'** are generated by moving the workbench The first writing field **22-1'** which has been moved twice, the position coordinates are changed from (C1Lx', C1Rx') to (C1Lx", C1Rx"), and the position of the second writing field moved out of the exposure area after correction The coordinates change from (C2Lx', C2Rx') to (C2Lx", C2Rx"), and this second writing field becomes the second writing field after the movement **(22-2")**, which is the third writing field **(22-3')** Move into the exposure area to make place.

Step 12: Start the nano contact sensor **39** again to recognize the alignment coordinate mark in the second writing field **22-2"** removed from the exposure area, and determine and memorize its position coordinates (C2L1"; C2L2; C2L3"; C2R1"; C2R2"; C2R3") on the surface of the workbench **38**.

Step 13: Taking the data of the alignment coordinate mark in the second writing field after the movement as the basis of closed-loop feedback control, the deviation of the actual coordinates before and after the movement is calculated to determine the correction value $\Delta X_2$ and $\Delta Y_2$ of the writing field of the next exposure area of the electron beam: Suppose that the coordinates of the third writing field that is adjacent to the moved second writing field that has moved out of the exposure area and is about to be exposed are C2R1", that is, coordinates $(X_{C2R1"}, Y_{C2R1"})$. This is also the corrected coordinates of the third writing field to be exposed which is needed to be stitched to the moved second writing field, that is $(X_{C3L1"}, Y_{C3L1"})$: $X_{C3L1"}=X_{C2R1"}$, $Y_{C3L1"}=Y_{C2R1"}$;

Electron beam at this time is located in the exposure area of the third write field coordinates are C3L1, that is, the coordinates $(X_{C3L1}, Y_{C3L1})$, and the coordinate difference between it and the second writing field that has been moved to follow the stitching exposure is this coordinate point. By adding deflection voltage to the electron beam, the edge C2R1" of the second writing field **22-2"** that has been moved is stitched and exposed, and the relevant coordinate points of the corrected third writing field **22-3"** are C3L1", the coordinate difference of C3L1" and C3L1' is:

$$\Delta X_2 = X_{C3L1"} - X_{C3L1'} = X_{C2R1"} - X_{C3L1'}$$

$$\Delta Y_2 = Y_{C3L1"} - Y_{C3L1'} = Y_{C2R1"} - Y_{C3L1'};$$

The overall electron beam drift of the second writing field and the third writing field exposed by the electron beam in the exposure area is ignored, so that the coordinates of the third writing field before the correction of the exposure coordinate in the exposure area are equal to the second writing field coordinates during exposure: $X_{C3L1'}=X_{C2L1'}$, $Y_{C3L1'}=Y_{C2L1'}$, so that the coordinates can be measured by the concave-convex structure formed by the exposure on the surface of the photosensitive resist layer after the second writing field is exposed and before moving the workbench to obtain the coordinate difference to be compensated for the electron beam coordinate correction of all the writing field exposure points:

$$\Delta X_2 = X_{C2R1"} - X_{C2L1'};$$

$$\Delta Y_2 = Y_{C2R1"} - Y_{C2L1'}.$$

Step 14: Adjust the deflection voltage of the electron beam column **32** according to the obtained correction value, and correct the electron beam exposure area so that the coordinates of all the exposure points in the third writing field of the subsequent wafer are corrected to be the same as the moved second writing field The adjacent stitching coordinates are consistent and seamless.

Step 15: Repeatedly, complete the exposure, movement and stitching of the entire writing field area of the entire wafer.

In this embodiment:
The electron beam may also be any of ion beam, photon beam or atomic beam.

The nano-contact sensor **39** may be one or a combination of one or more of an atomic force tip sensor, a tunnel electron probe sensor, or a nano-level surface work function measurement sensor.

The in-situ alignment coordinate mark **8**, the in-situ alignment coordinate mark **10**, and the in-situ alignment coordinate mark **18** may be graphic marks of a plane structure, which are provided with 1, 2, 3, 4, 5 or 6 on a plane, you can also use more according to actual needs. The graphic mark of the plane structure mentioned here is in a broad sense, and especially it also comprises the graphic mark formed by the small geometric structure change induced by the electron beam on the surface of the photoresist layer.

In this embodiment, a graphic mark formed by a slight geometric structure change caused by the surface of the photoresist layer induced by an electron beam is used as a planar structure graphic mark.

The in-situ alignment coordinate mark **43**, **44** may also be a three-dimensional shape mark. The specific shape is preferably a pyramid or cone shape. The mark may also be provided with 1, 2, 3, 4, 5, 6 or more on a plane.

In this embodiment, there are preferably 1-4 nano contact sensors **39** distributed around the exposure area.

The nano-contact sensor **39** is provided with a lever-type sensing contact arm **391**, and the contact arm **391** is provided with one or more needle tip sensing contacts **392** arranged in rows.

The electron beam can be a Gaussian beam or a Variable Shaped Beam.

The measurement method of electron beam drift is shown in FIGS. **7A** and **7B**: it comprises the following steps. In the chamber **31** of the lithography system, the stage **37**, the electron beam column **32** and its electron gun **372**, and the wafer moving stage **38** and nano contact sensor **39** are first set up; the wafer stage **38** is equipped with a numerical control driving device **371** that controls its movement, and a photosensitive resist layer is coated on the wafer, and then an electron gun **372** is used to emit an electron beam **17** to irradiate the focused point to the photosensitive resist. The light-sensitive resist layer is exposed to light, and the surface of the photosensitive resist layer is exposed to a small change in the geometric shape of the concave-convex structure induced by the electron beam. The small change is measured and the focus drift is tracked over time, and then the electron beam over time is recorded, also the coordinate value and drift amount of the drift trajectory **30**. And then according to the recorded coordinate value and drift amount of the drift trajectory **30** of the electron beam over time, the exposure coordinate value and the correction compensation difference value due to the drift of the electron beam over time between the start and end intervals are calculated to obtain the correction coordinate of the next writing field exposure.

As shown in FIG. **8**, the nano-contact sensor **39** is provided with a lever-type sensing contact arm **391**, and the contact arm **391** is provided with one or more needle tip sensing contacts **392** arranged in rows.

The vertical stitching method of sub-nano-level high-precision lithography writing field is shown in FIG. **11**: firstly, a three-dimensional alignment mark **43** with a protruding structure is preset on the wafer to be lithographically processed, and then coated with the photosensitive resist layer **2** to generate a corresponding protruding structure of the photosensitive resist layer three-dimensional alignment mark **44** at the position where the three-dimensional alignment mark is preset, and then the wafer with the three-dimensional alignment mark **1** is moved by the wafer workbench **38** to the area of the writing field that can be exposed by the electron beam **4**, align the electron beam **4** at the position of the three-dimensional alignment mark **44** of the photosensitive resist layer and perform spot exposure. The actual deviated three-dimensional mark **45** is generated outside the exposure point of the resist layer, and then the actual coordinate value of the three-dimensional alignment mark **44** and the deviated three-dimensional mark **45** is measured by the nano-contact sensor, and then calculated the correction value of the exposure area of the writing field, then control the electron gun to achieve vertical precise alignment and exposure, and achieve vertical precise stitching.

FIG. **12** is a schematic diagram of the nano-contact sensor with multiple nano-contacts **392** on each nano-contact sensor **39** being quickly stitched and aligned.

## Claims

1. A sub-nano-level high-precision photolithography writing field stitching method, **characterized in that** the method includes the following steps:

   step 1: in the chamber (31) of the lithography system, set the stage (37), the electron microscope column (32) and its electron gun (372), the wafer moving workbench (38) and at least one nano contact sensor (39); the wafer workbench (38) is equipped with a numerical control driving device (371) to control its movement; before the wafer is put into the photolithography system, the photosensitive resist layer (2) is coated on the entire wafer (1), the range of electron beam scanning is the exposure area (22), which divides the exposure area into several writing fields, and in each writing field on the photosensitive resist layer the in-situ aligns with the coordinate marks (8, 10, 18, 43, 44) are equipped with a specific shape that will be exposed in the exposure area after exposure; the writing fields are the first writing field (22-1), the second writing field (22-2),..., the Nth writing field (22-n);

Step 2: Place the wafer (1) coated with the photosensitive resist layer (2) on the workbench (38), and make the first writing field (22-1) of the wafer enter into the exposure area (22); the electron beam column (32) of the electron microscope is perpendicular to the exposure area (22), and then the electron beam is focused on the writing field;

Step 3: Expose a part of the wafer on the first writing field (22-1) in the exposure area (22), so that the photoresist coated on the part of the wafer undergoes a chemical reaction after exposure to cause electron beam-induced changes to generate at least one or a group of concave-convex structures with constitute graphics; the specific shape of the concave-convex structure is used as the feature shape of the preset in-situ alignment coordinate mark, and the coordinate value of the feature point in the exposure area is used as the in-situ alignment coordinate;

Step 4: Enable the nano contact sensor (39) to firstly measure the surface shape of the concave-convex structure, and then identify the above-mentioned alignment coordinate mark against the preset specific shape, and then determine and memorize its coordinate value (C1L1; C1L2; C1L3; C1R1; C1R2; C1R3) on the workbench;

Step 5: Perform pre-exposure preparation for the second writing field; drive the workbench (38) to move the wafer (1) horizontally and/or longitudinally, so that the first writing field area (22-1) that has just been exposed is moved out of the exposure area and becomes the writing field 22-1' to make place for the subsequent second writing field (22-2) of the wafer to enter the exposure area;

Step 6: Start the nano contact sensor (39) to recognize the alignment coordinate mark in the first writing field (22-1') moved out of the exposure area, and determine and memorize the location coordinates (C1L1'; C1L2'; C1L3'; C1R1'; C1R2'; C1R3') of the first writing field on the workbench after its movement;

Step 7: Use the data of the alignment coordinate mark in the first writing field (22-1') after the movement as the reference of closed-loop feedback control, calculate the actual coordinate deviation before and after the movement of the writing field, and then determine the coordinate correction value for the next entire exposure of the electron beam area:

Suppose that the coordinates of the second writing field (22-2') adjacent to the first writing field (22-1') that has been moved out of the exposure area are C1R1', that is, the coordinates ($X_{CiR1'}$, $Y_{C1R1'}$), this is also the new coordinate of the second writing field (22-2') to be exposed, which needs to be seamlessly stitched to the moved first writing field (22-1'), namely:

$$(X_{C2L1'}, Y_{C2L1'}): X_{C2L1'}=X_{C1R1'}, \ Y_{C2L1'}=Y_{C1R1'};$$

the electron beam is now facing the second writing field (22-2) located in the exposure area (22) before the error correction with the coordinates of C2L1, namely ($X_{C2L1}$, $Y_{C2L1}$); since this coordinate requires the stitch correction exposure of the coordinates of the second writing field (22-2) against the edge coordinates C1R1' of the first writing field (22-1') that has been moved by applying a deflection voltage to the electron beam, the corrected second writing field related coordinate is C2L1', and the coordinate difference between C2L1' and C2L1 is:

$$\Delta X_1 = X_{C2L1'} - X_{C2L1} = X_{C1R1'} - X_{C2L1}$$

$$\Delta Y_1 = Y_{C2L1'} - Y_{C2L1} = Y_{C1R1'} - Y_{C2L1}$$

given that the second writing field and its coordinates ($X_{C2L1}$, $Y_{C2L1}$) cannot be obtained because the workbench has not moved and has not been exposed, the overall electron beam drift between the first writing field and the second writing field in the exposure area is firstly ignored, so that the coordinates of the second writing field (22-2) in the exposure area before exposure and before correction are equal to the coordinates of the first writing field (22-1) in the exposure area during exposure: $X_{C2L1}=X_{C1L1}$, $Y_{C2L1}=Y_{C1L1}$, so that the coordinates can be measured by the concave-convex structure formed by the exposure of the photosensitive resist layer before the workbench moves after exposing the first writing field, so as to obtain the coordinate difference of all the electron beam coordinates in the second writing field that needed to be compensated:

$$\Delta X_1 = X_{C1R1'} - X_{C1L1}$$

$$\Delta Y_1 = Y_{C1R1'} - Y_{C1L1};$$

Step 8: Adjust the deflection voltage of the electron beam column (32) and correct the electron beam exposure area according to the obtained coordinate difference ($\Delta X_1$, $\Delta Y_1$) that needs to be compensated, and correct the stitching coordinates (C2L1; C2L2; C2L3; C2R1; C2R2; C2R3;) of the second writing field (22-2) which subsequently enters the exposure area to the adjacent stitching coordinates of the moved first writing field, and the corrected stitching coordinates of the second writing field (22-2') are seamlessly stitched with the first writing field after the movement.

2. The sub-nano-level high-precision lithography writing field stitching method according to claim 1, **characterized in that** it further comprises the following steps:

Step 9: Perform electron beam exposure on the part of the wafer in the second writing field (22-2') that is moved to the exposure area corrected by the electron beam exposure coordinates, so that the photosensitive resist coated on the exposed part of the wafer is subjected to chemical reaction to expose the preset alignment coordinate marks in the writing field **characterized by** the specific concave-convex structure;

Step 10: Start the nano contact sensor (39) to identify the above-mentioned alignment coordinate marks against the preset specific shape, determine and memorize the position coordinates (C2L1'; C2L2'; C2L3'; C2R1'; C2R2'; C2R3') of the characteristic coordinate points in the corrected second writing field (22-2') on the workbench;

Step 11: Perform pre-exposure preparations for the third writing field, drive the workbench (38) again to move the wafer (1) horizontally and/or longitudinally, so that the first writing field (22-1') and the corrected second writing field (22-2') that has just been exposed are moved, so that the corrected second writing field that has just been exposed is moved out of the exposure area; by the stage movement, the position coordinates of the first writing field (22-1') which has previously moved are changed to become the secondarily moved first writing field (22-1'), the position coordinates are changed from (C1Lx', C1Rx') to (C1Lx', C1Rx'), the position coordinates of the second writing field which has been moved out of the exposure area after correction are changed from (C2Lx', C2Rx') to (C2Lx', C2Rx'), the second writing field becomes a shifted second writing field (22-2') to make place for a subsequent third writing field (22-3') of the wafer to move into the exposure area;

Step 12: Start the nano contact sensor (39) again to recognize the alignment coordinate marks in the second writing field (22-2") removed from the exposure area, determine and memorize its position coordinates (C2L1"; C2L2"; C2L3"; C2R1"; C2R2"; C2R3") on the surface of the workbench (38);

Step 13: Taking the data of the alignment coordinate marks in the second writing field after the movement as reference of closed-loop feedback control, the deviation of the actual coordinates before and after the movement is calculated to determine the correction value $\Delta X_2$ and $\Delta Y_2$ of the writing field of the next exposure area of the electron beam:

suppose that the coordinates of the third writing field that is adjacent to the moved second writing field that has moved out of the exposure area and is about to be exposed are C2R1", that is, coordinates ($X_{C2R1}$", $Y_{C2R1}$"); this is also the third writing field to be exposed, which is needed to be stitched to the corrected coordinates of the moved second writing field, namely:

$$(X_{C3L1"}, Y_{C3L1"}):\ X_{C3L1"} = X_{C2R1"},\ Y_{C3L1"} = Y_{C2R1"};$$

the electron beam is now facing the third writing field located in the exposure area with the coordinates of C3L1, namely ($X_{C3L1}$, $Y_{C3L1}$); the coordinate difference between it and the moved second writing field, which is to be stitched and exposed as following, is this coordinate point to be stitched against the edge C2R1" of the moved second writing field (22-2") by adding deflection voltage to the electron beam; the corrected related coordinate of the third writing field (22-3") is C3L1", and the coordinate difference between C3L1" and C3L1' is:

$$\Delta X_2 = X_{C3L1"} - X_{C3L1'} = X_{C2R1"} - X_{C3L1'}$$

$$\Delta Y_2 = Y_{C3L1"} - Y_{C3L1'} = Y_{C2R1"} - Y_{C3L1'};$$

the overall electron beam drift of the second writing field and the third writing field exposed by the electron beam in the exposure area is ignored, so that the coordinates of the third writing field before the correction of the exposure coordinate in the exposure area are equal to the second writing field coordinates during exposure: $X_{C3L1'} = X_{C2L1'}$, $Y_{C3L1'} = Y_{C2L1'}$, so that the coordinates can be measured by the concave-convex structure formed by the exposure on the surface of the photosensitive resist layer after the second writing field is exposed and before moving the workbench to obtain the coordinate difference to be compensated for the electron beam coordinate correction of all the writing field exposure points:

$$\Delta X_2 = X_{C2R1"} - X_{C2L1'}$$

$$\Delta Y_2 = Y_{C2R1"} - Y_{C2L1'};$$

Step 14: Adjust the deflection voltage of the electron beam column (32) according to the obtained correction value, and correct the electron beam exposure area so that the coordinates of all exposure points in the third writing field of the subsequent wafer are corrected to be consistent with the stitching coordinates adjacent to the second writing field after moving, and enabling the electron beam exposure area to be stitched seamlessly; and

Step 15: Repeatedly, complete the exposure, movement and stitching of the entire writing field area of the entire wafer.

3. The sub-nano-level high-precision lithography writing field stitching method according to claim 1, wherein sub-nano-level high-precision lithography writing field stitching method according to claim 1, wherein the electron beam can also be an ion beam, a photon beam or an atomic beam.

4. The sub-nano-level high-precision lithography writing field stitching method according to claim 1, wherein the nano-contact sensor (39) is one or more combinations of an atomic force tip sensor, a tunnel electron probe sensor or a nano-level surface work function measurement sensor.

5. The sub-nano-level high-precision lithography writing field stitching method according to claim 1, wherein the wafer includes an entire complete wafer, a part of a wafer, or non-wafer materials that require lithography writing field stitching processing.

6. The sub-nano-level high-precision lithography writing field stitching method according to claim 1, **characterized in that** the in-situ alignment coordinate marks (8, 10, 18) are graphic marks with a planar structure.

7. The sub-nano-level high-precision lithography writing field stitching method according to claim 6, wherein the planar structure pattern mark is provided with 1, 2, 3, 4, 5, 6 or more on a plane.

8. The sub-nano-level high-precision lithography writing field stitching method according to claim 6, **characterized in that** the planar structure pattern mark includes a pattern mark formed by an electron beam inducing a surface of the photoresist layer to produce a small geometric structure change.

9. The sub-nano-level high-precision lithography writing field stitching method according to claim 1, wherein the in-situ alignment coordinate marks (43, 44) are three-dimensional shape marks.

10. The sub-nano-level high-precision lithography writing field stitching method according to claim 9, wherein the three-dimensional shape mark is pyramid-shaped or cone-shaped, and the mark is provided with 1, 2, 3, 4 on a plane, 5, 6 or more.

11. The sub-nano-level high-precision lithography writing field stitching method according to any one of claims 1-10, **characterized in that** the nano-contact sensor (39) is provided with 1, 2, 3 or 4 or More, distributed around the exposure area.

12. The sub-nano-level high-precision lithography writing field stitching method according to claim 11, **characterized in that** the nano-contact sensor (39) is provided with a lever type sensing contact arm (391), and the contact arm (391) is provided with one or more needle point sensing contacts (392) arranged in a row.

13. The sub-nano-level high-precision lithography writing field stitching method according to any one of claims 1-10, wherein the electron beam is a Gaussian Beam.

14. The sub-nano-level high-precision lithography writing field stitching method according to any one of claims 1-10, wherein the electron beam is a Variable Shaped Beam.

15. A sub-nano-level high-precision writing field stitching lithography system, comprising a stationary chamber (31) and a stage (37) in the chamber; an electron microscope and at least one nano-contact sensor (39) are arranged on the wafer moving workbench (38); electron beam column (32) is provided on the electron microscope; wafer workbench (38) is provided with numerical control driving device (371) for dragging its front, back and/or left, right and/or upward, downward movement and changing its angle.

16. The sub-nano-level high-precision writing field stitching lithography system according to claim 15, **characterized in that** the lithography system further comprises a control computer (42), which is combined with a pattern generator (46) and an electron beam control system (34) is connected with the numerical control driving device (371) of the wafer workbench (38), and the nano-contact sensor (39) sends the collected in-situ alignment coordinate identification signal (40) and/or the electron beam drift signal (40) on the measured wafer to the pattern generator (46) under the control of the control computer (42), and the pattern generator (46) sends the corrected electron beam scanning control signal after operation processing to the electron beam control system (34) under the control of the control computer (42), and the electron beam control system (34) controls the shutter of the focusing system (32) on the electron beam column (32) and the deflection coil (35).

17. The sub-nano-level high-precision writing field stitching lithography system according to claim 15, **characterized in that** the electron beam column (32) is also provided with a secondary electron imaging signal acquisition device (36), which collects the secondary image scanned by the electron beam is fed back to the control computer (42) through the electron beam control system (34).

18. The sub-nano-level high-precision writing field stitching lithography machine system according to claim 15, wherein the nano-contact sensor (39) is one or more of an atomic force tip sensor, a tunnel electron probe sensor or a nano-level surface work function measurement sensor.

19. The sub-nano-level high-precision writing field stitching lithography system according to claim 15, **characterized in that** the nano-contact sensor (39) is provided with a lever-type sensing contact arm (391), and the contact arm (391) is equipped with a needle tip sensing contact (392).

20. The sub-nano-level high-precision writing field stitching lithography system according to claim 19, **characterized in that** each of the contact arms (391) is provided with one or more needle tip sensing contacts (392).

21. The sub-nano-level high-precision writing field stitching lithography machine system according to claim 19, **characterized in that** each contact arm (391) is provided with at least one row of needle tip sensing contacts, and each row is provided with more than one tip sensing contact (392).

22. The sub-nanometer high-precision writing field stitching lithography system according to any one of claims 15 to 21, **characterized in that** the nano-contact sensor (39) is provided with 2 rows arranged on both sides of the electron beam column (32), and each row is provided with 4 contact sensors.

23. The sub-nano-level high-precision writing field stitching lithography system according to claim 22, **characterized in that** the electron beam column (32) is directly facing the exposure area (22) of the wafer on the workbench (38).

24. A pre-processed wafer is coated with a photosensitive resist layer to be exposed, and is **characterized in that** an in-situ alignment coordinate mark (8, 10, 18, 43, 44) which has a specific concave and/or convex shape and used for a nano contact sensor (39) to recognize an in-situ coordinate is arranged inside a writing field area of the wafer and/or the photosensitive resist layer thereof after electron beam exposure.

25. The pre-processed wafer according to claim 24, **characterized in that** the in-situ alignment coordinate marks (8, 10, 18) are graphic marks with a planar structure.

26. The pre-processed wafer according to claim 25, **characterized in that** there are 1, 2, 3, 4, 5, 6 or more of the planar structure graphic marks on a plane.

27. The pre-processed wafer according to claim 26, wherein the planar structure pattern mark is a pattern mark formed by an electron beam inducing a small geometric structure change on the surface of the photoresist layer.

28. The pre-processed wafer according to claim 24, **characterized in that** the in-situ alignment coordinate marks (43, 44) are three-dimensional shape marks.

29. The pre-processed wafer according to claim 28, wherein the three-dimensional shape mark is provided with 1, 2, 3, 4, 5, 6 or more on a plane.

30. The pre-processed wafer according to any one of claims 24 to 29, wherein the wafer includes an entire complete wafer, a partial wafer, or a non-wafer material that requires a photolithography writing field stitching process.

31. The method for measuring electron beam drift is **characterized by** the following steps: a stage (37), an electron microscope lens column (32) and an electron gun (372) thereof, a wafer moving workbench (38) and a nano contact sensor (39) are arranged in a machine chamber (31) of a lithography system; the wafer workbench (38) is equipped with a numerical control driving device (371) to control its movement, and a photosensitive resist layer is coated on the wafer, and then used the electron gun (372) emits an electron beam (17) to irradiate the photosensitive resist layer at the focal point, and exposes it; through the exposure, the surface of the photosensitive resist layer produces a small change in the geometric shape of the concave-convex structure induced by the electron beam. The small change is measured and the drift of the focus point along with time is tracked, and then the coordinate value and the drift amount of a drift track (30) of the electron beam along with the time are recorded.

32. The method for measuring electron beam drift according to claim 31, **characterized by** further comprising the step of: calculating exposure coordinate values and correction compensation differences generated by the drift of the electron beams over time in the initial and final interval time periods according to the recorded coordinate values and the drift amount of the drift track (30) of the electron beams over time, and obtaining correction coordinates of the next writing field exposure.

33. The vertical stitching method of sub-nano-level high-precision lithography writing field is **characterized in that**: firstly, a three-dimensional alignment mark (43) with a protruding structure is preset on the wafer to be lithographically processed, and then coated with the photosensitive resist layer (2) to generate a corresponding protruding structure of the photosensitive resist layer three-dimensional alignment mark (44) at the position where the three-dimensional alignment mark is preset, and then the wafer with the three-dimensional alignment mark (1) is moved by the wafer workbench (38) to the area of the writing field that can be exposed by the electron beam (4), align the electron beam (4) at the position of the three-dimensional alignment mark (44) of the photosensitive resist layer and perform spot exposure; the actual deviated three-dimensional mark (45) is generated outside the exposure point of the resist layer, and then the actual coordinate value of the three-dimensional alignment mark (44) and the deviated three-dimensional mark (45) is measured by the nano-contact sensor, and then calculated the correction value of the exposure area of the writing field, then control the electron gun to achieve vertical precise alignment and exposure, and achieve vertical precise stitching.

**FIG. 1A**

**FIG. 1B**

**FIG. 2A**

**FIG. 2B**

**FIG. 3**

**FIG. 4**

23

22

24 △

**FIG. 5A**

23

25

26

24 △

27

28

**FIG. 5B**

29x

29y

23

25

26

24 △

27

28

**FIG. 5C**

23

22

24

**FIG. 6A**

22'

22

24

**FIG. 6B**

17

29

2

1

**FIG. 7A**

17

17'

2

30

1

**FIG. 7B**

FIG. 8

EP 4 167 268 A1

C1L1 ✕ — — ✕ C1R1

C1L2 ✕ — — ✕ C1R2

C1L3 ✕ — — ✕ C1R3

22

**FIG. 9A**

FIG. 9B

C2R1   C2R2   C2R3

C2L1   C2L2   C2L3

C1R1'   C1R2'   C1R3'

C1L1'   C1L2'   C1L3'

22-2
(22-1)

22-1'

$(\Delta X, \Delta Y)$
Displacement of the
first writing field

Exposure area
of the first
writing field

FIG. 9C

FIG. 9D

Error compensation of electron
beam exposure area;  Formation
of a new exposure area

22-1"

22-2"

22-3"

22-3'

**FIG. 9E**

EP 4 167 268 A1

22-1'''

22-2'''

22-3'''

22-4"
(22-3")

Third movement of
workbench ($\triangle X3$, $\triangle Y3$)

**FIG. 9F**

39,392    39,392

C1L1 ✕        ✕ C2R1

ALB    C1L2 ✕        ✕ C2R2    C2RB
C1L3 ✕        ✕ C2R3

22

**FIG. 10A**

C1L1' ✕        ✕
C1R1'        ✕ C2L1        ✕ C2R1

C1L2' ✕        ✕
C1R2'        ✕ C2R2
C1L3' ✕        ✕ C1R3'    C2L2 ✕
C2L3        ✕ C2R3

22-1'    22-2
22-1
(ΔX1, ΔY1)

**FIG. 10B**

**FIG. 11**

**FIG. 12**

## INTERNATIONAL SEARCH REPORT

International application No.

**PCT/CN2021/096009**

### A.  CLASSIFICATION OF SUBJECT MATTER

H01J 37/317(2006.01)i;  H01J 37/304(2006.01)i;  G03F 7/20(2006.01)i

According to International Patent Classification (IPC) or to both national classification and IPC

### B.  FIELDS SEARCHED

Minimum documentation searched (classification system followed by classification symbols)

H01J37/-; G03F7/-; G03F9/-

Documentation searched other than minimum documentation to the extent that such documents are included in the fields searched

Electronic data base consulted during the international search (name of data base and, where practicable, search terms used)

CNTXT; CNABS: 光刻, 曝光, 晶圆, 标记, 标志, 标识, 触点, 触头, 原子力, 隧道, 功函数, 探针, 光敏胶, 光刻胶, 对准, 对齐, 离子束, 原子束, 光子数, 电子束, 位置, 坐标, 位移, 漂移; VEN, USTXT; JPTXT; TWTXT; WOTXT: litho+, photoetch+, exposure, mark, touch+, contact+, AFM, STM, work function, Kelvin, probe?, photo resist+, photo sensi+, align+, atomic, ion, photon, elctron, beam, position, coordinate, displac+, drift+, shift+, slip+

### C.  DOCUMENTS CONSIDERED TO BE RELEVANT

| Category* | Citation of document, with indication, where appropriate, of the relevant passages | Relevant to claim No. |
|---|---|---|
| PX | CN 212873186 U (PARCANNANO TECHNOLOGY (SHANGHAI) CO., LTD.) 02 April 2021 (2021-04-02)<br>description, paragraphs [0052]-[0161], and figures 1-12 | 1-33 |
| PX | CN 111983899 A (PARCANNANO TECHNOLOGY (SHANGHAI) CO., LTD.) 24 November 2020 (2020-11-24)<br>claims 1-33 | 1-33 |
| Y | CN 1300097 A (NEC CORPORATION) 20 June 2001 (2001-06-20)<br>description, page 1, line 10 to page 7, line 29, and figures 1-5 | 15-32 |
| A | CN 1300097 A (NEC CORPORATION) 20 June 2001 (2001-06-20)<br>description, page 1, line 10 to page 7, line 29, and figures 1-5 | 1-14, 33 |
| Y | US 5130554 A (CANON K. K.) 14 July 1992 (1992-07-14)<br>description, column 6, line 40 to column 9, line 24, and figures 1-4 | 15-32 |
| A | US 5130554 A (CANON K. K.) 14 July 1992 (1992-07-14)<br>description, column 6, line 40 to column 9, line 24, and figures 1-4 | 1-14, 33 |

☑ Further documents are listed in the continuation of Box C.      ☑ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **23 June 2021** | **07 July 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2021/096009** |

### C. DOCUMENTS CONSIDERED TO BE RELEVANT

| Category* | Citation of document, with indication, where appropriate, of the relevant passages | Relevant to claim No. |
| --- | --- | --- |
| A | CN 108573844 A (HITACHI, LTD.) 25 September 2018 (2018-09-25)<br>    entire document | 1-33 |
| A | JP 4416195 B2 (CANON K. K.) 17 February 2010 (2010-02-17)<br>    entire document | 1-33 |
| A | US 2006063078 A1 (TOSHIBA K. K.) 23 March 2006 (2006-03-23)<br>    entire document | 1-33 |
| A | US 2011253892 A1 (CANON K. K.) 20 October 2011 (2011-10-20)<br>    entire document | 1-33 |
| A | US 2014320836 A1 (CANON K. K.) 30 October 2014 (2014-10-30)<br>    entire document | 1-33 |

Form PCT/ISA/210 (second sheet) (January 2015)

**INTERNATIONAL SEARCH REPORT**

| International application No. |
| --- |
| **PCT/CN2021/096009** |

**Box No. III**      **Observations where unity of invention is lacking (Continuation of item 3 of first sheet)**

This International Searching Authority found multiple inventions in this international application, as follows:

[1]    Claims 1-14 relate to sub-nanometer high-precision lithographic write-field splicing methods.

[2]    Claims 15-23 relate to sub-nanometer optical precision write-field splicing lithographic systems.

[3]    Claims 24-30 relate to pre-processed wafers.

[4]    Claims 31 and 32 relate to methods for determining electron beam drift.

[5]    Claim 33 relates to the method of longitudinal splicing of sub-nanometer high-precision lithographic writing fields.

1. ☐   As all required additional search fees were timely paid by the applicant, this international search report covers all searchable claims.

2. ☑   As all searchable claims could be searched without effort justifying additional fees, this Authority did not invite payment of additional fees.

3. ☐   As only some of the required additional search fees were timely paid by the applicant, this international search report covers only those claims for which fees were paid, specifically claims Nos.:

4. ☐   No required additional search fees were timely paid by the applicant. Consequently, this international search report is restricted to the invention first mentioned in the claims; it is covered by claims Nos.:

**Remark on Protest**      ☐   The additional search fees were accompanied by the applicant's protest and, where applicable, the payment of a protest fee.

                                         ☐   The additional search fees were accompanied by the applicant's protest but the applicable protest fee was not paid within the time limit specified in the invitation.

                                         ☐   No protest accompanied the payment of additional search fees.

Form PCT/ISA/210 (continuation of first sheet) (January 2015)

**INTERNATIONAL SEARCH REPORT**
Information on patent family members

International application No.

**PCT/CN2021/096009**

| Patent document cited in search report | | | Publication date (day/month/year) | Patent family member(s) | | | Publication date (day/month/year) |
|---|---|---|---|---|---|---|---|
| CN | 212873186 | U | 02 April 2021 | None | | | |
| CN | 111983899 | A | 24 November 2020 | None | | | |
| CN | 1300097 | A | 20 June 2001 | KR | 20010062289 | A | 07 July 2001 |
| | | | | US | 2001003655 | A1 | 14 June 2001 |
| | | | | JP | 2001168013 | A | 22 June 2001 |
| | | | | CN | 1144267 | C | 31 March 2004 |
| | | | | KR | 100372060 | B1 | 14 February 2003 |
| | | | | TW | 473848 | B | 21 January 2002 |
| | | | | US | 6436594 | B2 | 20 August 2002 |
| US | 5130554 | A | 14 July 1992 | EP | 0398334 | B1 | 21 September 1994 |
| | | | | DE | 69012644 | D1 | 27 October 1994 |
| | | | | EP | 0398334 | A1 | 22 November 1990 |
| | | | | DE | 69012644 | T2 | 06 April 1995 |
| | | | | JP | H02303021 | A | 17 December 1990 |
| CN | 108573844 | A | 25 September 2018 | JP | 2018152165 | A | 27 September 2018 |
| | | | | JP | 6760870 | B2 | 23 September 2020 |
| | | | | EP | 3373322 | B1 | 16 October 2019 |
| | | | | US | 2018261423 | A1 | 13 September 2018 |
| | | | | CN | 108573844 | B | 24 December 2019 |
| | | | | EP | 3373322 | A1 | 12 September 2018 |
| | | | | US | 10276341 | B2 | 30 April 2019 |
| JP | 4416195 | B2 | 17 February 2010 | JP | 2000133566 | A | 12 May 2000 |
| US | 2006063078 | A1 | 23 March 2006 | US | 2002151140 | A1 | 17 October 2002 |
| | | | | US | 7011915 | B2 | 14 March 2006 |
| | | | | JP | 2003007613 | A | 10 January 2003 |
| | | | | US | 7264909 | B2 | 04 September 2007 |
| US | 2011253892 | A1 | 20 October 2011 | EP | 2381462 | A2 | 26 October 2011 |
| | | | | JP | 2011243957 | A | 01 December 2011 |
| | | | | JP | 5744601 | B2 | 08 July 2015 |
| US | 2014320836 | A1 | 30 October 2014 | JP | 2014220262 | A | 20 November 2014 |

Form PCT/ISA/210 (patent family annex) (January 2015)